# FASCICULE DE BREVET EUROPEEN

(11) **EP 1 548 431 B1**
(45) Date de publication et mention de la délivrance du brevet: **09.07.2008**
(21) Numéro de dépôt: 04106173.0
(22) Date de dépôt: 30.11.2004
(51) Int. Cl.: G01N 33/00, C30B 7/00

(54) **Nanocristaux inorganiques à couche de revêtement organique, leur procédé de préparation**
Anorganische Nanokristalle mit einer organischen Beschichtung und deren Vorbereitungsverfahren
Inorganic nanocrystals with an organic coating and preparation process thereof

(30) Priorité: 02.12.2003 FR 0350954
(43) Date de publication de la demande: 29.06.2005
(73) Titulaire: COMMISSARIAT A L'ENERGIE ATOMIQUE, 75015 Paris (FR)
(72) Inventeur: REISS, Peter, 38120, SAINT-EGREVE (FR); QUERNER, Claudia, 38000, GRENOBLE (FR); CHARVET, Nicolas, 38340, VOREPPE (FR)
(74) Mandataire: Poulin, Gérard

(56) Documents cités:
- WO-A-01/71354
- WO-A-02/073155
- FR-A- 2 838 241
- US-B2- 6 444 143

## Description

### DOMAINE TECHNIQUE

L'invention a trait à des nanocristaux inorganiques qui sont pourvus d'une couche de revêtement organique, et aux matériaux constitués par ces nanocristaux.

Plus précisément, l'invention concerne des matériaux constitués par des nanocristaux constitués par au moins un métal et/ou au moins un composé semi-conducteur comprenant au moins un métal, et éventuellement une coquille constituée d'une ou plusieurs couches d'un métal et/ou d'au moins un composé semi-conducteur comprenant au moins un métal, dans lesquels la surface externe desdits nanocristaux est pourvue et enrobée d'une couche de revêtement organique, en particulier d'une couche de ligands tels que des ligands chélates destinés notamment à assurer la stabilisation des nanocristaux.

Dans le cas où ils comportent une (ou plusieurs) coquille, les nanocristaux sont encore appelés "nanocristaux coeur/coquille" (ou "core-shell" en anglais). L'invention concerne en particulier les matériaux luminescents constitués par des nanocristaux comprenant un coeur de semi-conducteur A(II)B(VI), de préférence entouré d'une coquille, et une couche de revêtement organique. Plus précisément, l'invention concerne des nanocristaux avec un coeur de CdSe recouvert par une coquille de ZnSe et par une couche de revêtement organique.

L'invention concerne, en outre, un procédé de préparation de ces nanocristaux et matériaux.

Le domaine technique de l'invention peut être défini de manière générale comme celui des nanocristaux inorganiques, plus précisément des nanocristaux constitués par au moins un métal et/ou au moins un composé semi-conducteur, ledit composé semi-conducteur comprenant au moins un métal.

Les nanocristaux peuvent être définis comme des objets cristallins "nanométriques", c'est-à-dire que leur taille est généralement inférieure à 150 Å et de préférence dans la gamme de 12 à 150 Å.

Les nanocristaux inorganiques trouvent des applications dans de nombreux secteurs.

Un grand nombre d'applications des nanocristaux inorganiques et particulièrement des nanocristaux semi-conducteurs est basé sur leur capacité à émettre de la lumière. De tels nanocristaux semi-conducteurs fluorescents peuvent être utilisés par exemple comme marqueurs fluorescents de molécules chimiques ou biologiques ou dans des dispositifs électroluminescents.

Afin d'obtenir une émission dans le spectre visible, on travaille essentiellement avec les nanocristaux de semi-conducteurs à petite largeur de bande interdite ("gap") en profitant du fait de pouvoir choisir, pour un matériau donné, la couleur émise en fonction de la taille du nanocristal.

Les nanocristaux de semi-conducteurs luminescents sont généralement constitués par des semi-conducteurs de formule A(II)B(VI), dans laquelle A représente un métal ou un métalloïde à l'état d'oxydation +II, et B représente un élément chimique, tel qu'un métal ou un métalloïde, à l'état d'oxydation -II.

Les cristaux de semi-conducteurs A(II)B(VI) comme par exemple ZnS, ZnSe, CdS, CdSe ou CdTe sont des matériaux connus pour leurs propriétés de photoluminescence depuis plusieurs décennies.

Dans les années 1980-90, il a été montré que leurs spectres d'absorption et d'émission dépendent de la taille du cristal lorsque celle-ci devient suffisamment petite. Pour des cristaux dont la taille se situe approximativement dans la gamme allant de 1 à 10 nm, qui sont alors appelés « nanocristaux » ou « boîtes quantiques » ("quantum dots" en anglais), cette dépendance est extrêmement prononcée (Angew. Chem. Int. Ed. Engl., 32, pages 41-53 (1993)).

De ce fait, la palette entière des couleurs du visible et des proches infrarouge et ultraviolet peut être obtenue avec des nanocristaux semi-conducteurs A(II)B(VI) par le choix approprié de leurs taille et composition.

D'une manière générale, la qualité optique d'un matériau luminescent fait de nanocristaux dépend de plusieurs paramètres, dont les plus importants sont :
- la taille des nanocristaux, qui règle la longueur d'onde de l'émission et donc la couleur émise, comme on l'a déjà indiqué ;
- la distribution de taille des nanocristaux, qui contrôle la largeur de raie d'émission ;
- la passivation de la surface des nanocristaux qui est responsable du rendement quantique de fluorescence.

Il existe plusieurs procédés de préparation des nanocristaux A(II)B(VI).

Les premiers procédés de préparation de ces cristaux furent développés en milieu aqueux (J. Am. Chem. Soc., 109, pages 5 649-5 655 (1987) ; J. Phys. Chem., 98, pages 7 665-7 673 (1994)) ou dans des mélanges eau/milieu organique : il s'agit, par exemple, du procédé dit des « micelles inverses » (Langmuir, 13, pages 3 266-3 276 (1997)).

Ces voies de synthèse aqueuse des nanocristaux de semi-conducteurs A(II)B(VI) conduisent néanmoins à des échantillons dont l'efficacité de luminescence réduite et l'importante largeur spectrale sont des inconvénients technologiques majeurs.

C'est pour ces raisons que d'autres procédés de préparation ont été développés.

L'article du J. Am. Chem. Soc., 115, pages 8 706-8 715 (1993) décrit ainsi une voie de synthèse organométallique des nanocristaux de CdB (où B = S, Se, Te). Le principal avantage de ce procédé organométallique par rapport aux procédés en milieu aqueux cités précédemment réside dans le fait que les nanocristaux ainsi préparés présentent une bien meilleure distribution de taille, qui est généralement inférieure à 10%.

Cette distribution de taille mène à un spectre d'émission bien plus étroit, ce qui est bien sûr avantageux pour les applications technologiques. Les principales voies de synthèse organométallique pour la préparation de nanocristaux de CdSe sont les suivantes :
- la voie de synthèse organométallique classique consiste à faire réagir du dialkylcadmium, de préférence du diméthyl ou du diéthylcadmium avec du sélénium, tous deux dispersés dans de la trioctylphosphine (TOP) ; cette dispersion est injectée dans du trioctylphosphine oxyde (TOPO) à haute température, qui sert de milieu réactif. Cette synthèse est décrite dans le document J. Am. Chem. Soc., 115, pages 8 706-8 715 (1993) ;
- une modification du procédé de synthèse précédent a été décrit dans le document Nanoletters, 1(4), pages 207-211 (2001), dans ce procédé, le milieu réactif, au lieu de TOPO, est un mélange de TOPO et d'hexadécylamine (HDA). Les auteurs rapportent une amélioration de la largeur de la distribution de taille qui se situe autour de 5% ;
- une autre modification a été proposée par Z. A. PENG et X. PENG, dans le document J. Am. Chem. Soc., 123, pages 183-184 (2001) ; ces auteurs décrivent une voie de synthèse inorganique/organométallique des nanocristaux CdB (où B est Se, S ou Te) dans laquelle ils remplacent les composés pyrophoriques et toxiques de dialkylcadmium par l'oxyde de cadmium (CdO) complexé par un acide alkylphosphonique. L'avantage principal de ce procédé est que CdO constitue une source de cadmium bien moins réactive et plus facile à manipuler que les composés dialkylcadmium. Un autre avantage est que les nanocristaux ainsi préparés ont une très faible distribution de taille, généralement inférieure à 10%, qui mène à un spectre d'émission étroit avec une largeur de raie à mi-hauteur de l'ordre de 30 nm.

Les procédés de préparation, décrits ci-dessus, ne résolvent pas le problème du rendement quantique de fluorescence qui demeure faible, à savoir typiquement entre 5 et 10% pour des cristaux de CdSe.

Dans l'article J. Phys. Chem., 100, pages 468-471 (1996), est proposé un procédé pour augmenter ce rendement. Il consiste à passiver des nanocristaux qui sont en CdSe, dans ce cas, en faisant croître autour de ce « coeur » une coquille d'un second semi-conducteur de largeur de bande interdite supérieure à celle du coeur, ce semi-conducteur étant constitué par du ZnS. Ce système est dénommé « coeur/coquille » dans la littérature scientifique. Les procédés utilisés pour le dépôt de la coquille sont essentiellement les mêmes que ceux employés pour la préparation du coeur. Le dépôt d'une coquille de ZnS se fait, par exemple, avec les composés hautement réactifs, que sont le diéthyl zinc et le bis(triméthylsilyl)sulfure. Après croissance de la coquille, les auteurs observent une augmentation du rendement quantique de fluorescence vers des valeurs comprises entre 10 et 50%, voire supérieures à 50%, à température ambiante.

M. G. BAWENDI et al. décrivent la préparation de ce même type de nanocristaux coeur/coquille CdSe/ZnS dans l'article J. Phys. Chem. B, 101, pages 9 463-9 475 (1997) et les brevets US-6 207 229 et WO-99/26299.

L'article J. Am. Chem. Soc., 119, pages 7 019-7 029 (1997) présente la préparation de nanocristaux coeur/coquille CdSe/CdS. Les auteurs rapportent une augmentation du rendement quantique de fluorescence à température ambiante jusqu'à une valeur d'au moins 50%.

Le document de P. REISS et al. Nano Lett. 2(7), p. 781-783 (2002) démontre qu'avec le système coeur/coquille CdSe/ZnSe dont la surface est pourvue d'une couche de passivation organique constituée d'au moins une amine primaire telle que l'hexadécylamine (HDA) associée à au moins un composé phosphine oxyde tel que le TOPO, et/ou à un séléniure de phosphine, des valeurs de rendement de 60 à 85% sont atteintes. Les mêmes nanocristaux et leur synthèse dans un solvant associant par exemple HDA et TOPO sont décrits dans la demande de brevet français FR-A-2 838 241.

Il ressort de ce qui précède que parmi les procédés connus jusqu'à ce jour le procédé de synthèse dit inorganique/organométallique permet de préparer des nanocristaux semi-conducteurs A(II)B(VI) ayant les meilleures propriétés optiques. En effet, les nanocristaux ainsi préparés, grâce à leur faible dispersion en taille ont des raies d'émission étroites et les systèmes coeur/coquilles présentent des valeurs de rendement quantique de fluorescence élevées (FR-A-2 838 241).

Dans le domaine du marquage biologique, les nanocristaux semi-conducteurs pourraient remplacer les colorants organiques, utilisés actuellement comme marqueurs fluorescents, avec l'avantage principal de mieux résister au vieillissement sous faisceaux lumineux (M. Bruchez et al., Science 281, p. 2013-2015 (1998)).

Cependant, cette application nécessite a priori un échange des molécules organiques issues de la synthèse inorganique/organométallique qui se trouvent à la surface des nanocristaux pour les raisons suivantes :
-1) les molécules présentes à la surface du nanocristal lui confèrent un caractère hydrophobe, ce qui empêche son utilisation dans un milieu physiologique, c'est-à-dire un milieu essentiellement aqueux,
-2) ces molécules ne permettent pas une liaison chimique avec les molécules biologiques qu'on veut marquer.

Les molécules en question sont des surfactants par exemple de type trialkylphosphine tel que le TOP, trialkylphosphine oxyde tel que le TOPO, acide alkylphosphonique, acide carboxylique ou alkylamine qui sont liés par leur tête polaire à la surface du cristal, tandis que leurs chaînes alkyles forment une couche hydrophobe vers l'extérieur. Ainsi, dans le document FR-A-2 838 241 déjà cité plus haut une couche formée par l'association d'une amine primaire et d'un composé phosphine oxyde ou séléniure de phosphine est-elle formée à la surface des nanocristaux.

Une possibilité de rendre les nanocristaux hydrosolubles et de permettre leur liaison avec des molécules biologiques est d'échanger les molécules à leur surface par des ligands bifonctionnels. Ces derniers possèdent à la fois une fonction avec une affinité pour la surface des nanocristaux et une fonction qui permet la solubilisation des nanocristaux dans l'eau et/ou la liaison avec une molécule biologique (W.C.W. Chan et al., Science 281, P. 2016-2018 (1998)).

Une autre application des nanocristaux semi-conducteurs qui ne repose pas sur leurs propriétés de photoluminescence est leur incorporation dans des films de polymères ou oligomères conjugués dans le but d'obtenir de nouveaux matériaux pour la conversion lumière-électricité pour effet photovoltaïque dans les cellules solaires. Les nanocristaux jouent le rôle d'absorbeur de lumière solaire et de transporteur d'électrons vers les électrodes (W.U. Huynh et al., Science 295, p. 2425 (2002)).

L'efficacité de ces matériaux est actuellement limitée par la difficulté de contrôler leur morphologie : ils sont élaborés par mélange de deux constituants, à savoir d'une part les nanocristaux et d'autre part, un polymère conjugué, ce qui entraîne un phénomène de ségrégation des phases en zones riches en polymères et zones riches en nanocristaux. De plus, l'interface entre les deux constituants n'est pas contrôlée ce qui empêche d'optimiser le transfert des porteurs des charges et réduit l'efficacité du matériau. Une possibilité d'amélioration consiste à greffer, en formant une liaison chimique, le polymère sur le nanocristal. Ainsi, la ségrégation des phases peut être évitée et l'interface entre les nanocristaux et le polymère est mieux définie. Cette approche a été mise en pratique récemment dans le document de D.J. Milliron et al., Adv. Mater. 15(1), P. 58 (2003) dans lequel un oligomère conjugué est modifié chimiquement afin d'introduire une fonction qui permet le greffage sur le nanocristal. Cependant, le procédé proposé nécessite une synthèse organique à multiples étapes, difficilement adaptable à un grand nombre de différents polymères/oligomères conjugués.

Au contraire, la conception des ligands bifonctionnels qui servent comme molécules de liaison entre le nanocristal d'une part et le polymère/oligomère d'autre part, donne beaucoup plus de flexibilité au niveau du choix des matériaux car il n'est pas nécessaire de changer les voies bien établies de préparation des polymères ou oligomères.

Ces ligands du type X-Y-Z portent une fonction X avec une forte affinité pour la surface des nanocristaux, un groupe dit "espaceur" Y qui peut être conjugué ou non-conjugué et une fonction Z qui permet la liaison avec le polymère/oligomère.

Il ressort de ce qui précède, que les applications potentielles des nanocristaux exigent, tout d'abord, un échange de molécules organiques à leur surface par des ligands bifonctionnels X-Y-Z qui permettent une dispersion dans l'eau ou le greffage à d'autres molécules.

Le type de ligand bifonctionnel utilisé actuellement dans la plupart des exemples de la littérature contient un ou plusieurs groupes thiol (-SH) comme fonction d'ancrage X pour la liaison avec la surface du nanocristal, on pourra à ce propos se reporter aux articles de W.C.W. Chan et al., Science 281, p. 2016-2018 (1998), et de S.F. Wuister et al., Nano Lett. 3(4), p. 503-507 (2003).

Les nanocristaux fonctionnalisés par des thiols afin de les rendre hydrosolubles font par exemple l'objet de la demande WO 00/17656 du 30 mars 2000.

Or, la publication J. Am. Chem. Soc. 123(36), p. 8844-8850 (2001) montre que les nanocristaux de CdSe avec des thiols à la surface sont sensibles au phénomène de photo-oxydation. Sous irradiation UV, les thiols se détachent de la surface en formant des disulfures. Ainsi, la couche organique qui protège le nanocristal colloïdal disparaît ce qui mène à sa précipitation. Ce processus est observé pour tous les types de ligands thiols et une comparaison de la stabilité montre que les thiols portant de longues chaînes alkyles sont plus stables que les thiols à courte chaîne et les thiols aromatiques. Cette étude montre aussi que la stabilité des ligands avec plusieurs groupes thiol sur la surface des nanocristaux n'est pas plus grande que celle des monothiols. Le phénomène de photo-oxydation qui entraîne une désorption des ligands thiols n'est pas limité aux nanocristaux de semi-conducteurs ; les nanocristaux d'or en sont un autre exemple important car les thiols sont les ligands les plus utilisés pour leur fonctionnalisation.

En conclusion, on peut constater que les ligands thiols utilisés actuellement pour la fonctionnalisation des nanocristaux ne sont pas photostables ce qui va limiter fortement les applications des nanocristaux ainsi modifiés. Le problème réside notamment dans la fonction d'ancrage (-SH) qui n'assure pas une liaison suffisamment stable avec la surface des différents types de nanocristaux.

D'autres documents concernant des nanocristaux fonctionnalisés sont les documents US-A-5 990 479 (du 23/11/99), le document US-B2-6 444 143 (du 3/09/2002) et le document WO-A-02/073155 (du 19/09/2002).

Le document US-A-5 990 479 concerne des nanocristaux semi-conducteurs luminescents qui sont liés à une molécule d'affinité par l'intermédiaire d'un agent de liaison ("linking agent").

La molécule d'affinité est susceptible de se lier à une substance détectable, et le nanocristal peut alors jouer le rôle de sonde, notamment dans des applications biologiques pour détecter la présence de ladite substance dans un matériau.

La molécule d'affinité est choisie par exemple parmi les ligands et l'agent de liaison est par exemple le thiol N-(3-aminopropyl-3 mercapto-benzamide.

Le document US-B2-6 444 143 décrit des nanocristaux fluorescents solubles dans l'eau, de préférence à structure coeur-coquille, qui comprennent une couche externe comprenant un composé ayant au moins un groupe de liaison pour accrocher le composé à la surface du nanocristal et au moins un groupe hydroxyle séparé du groupe de liaison par une région hydrophobe suffisante pour empêcher les transferts de charge au travers de celle-ci.

Pour préparer les nanocristaux, les ligands classiques tels que le TOPO se trouvant à la surface des nanocristaux sont remplacés par d'autres composés ligands qui peuvent être des ligands bidentate ou tridentate portant plusieurs groupes de liaisons tels que des thiols, le composé peut ainsi être un dithiol tel que l'acide dihydrolipoïque.

Les composés dithiolates ne sont pas cités dans ce document.

Le document WO-A-02/073155 décrit de même des nanocristaux semi-conducteurs à structure coeur-coquille qui sont pourvus d'un agent de solubilisation dans l'eau choisi notamment parmi les hydroxamates, ou les dérivés de l'acide hydroxamique ; les agents complexant multidentates ; une bicouche constituée d'une couche de TOPO fixé à la surface du nanocristal et d'une couche de surfactant ; une molécule contenant plusieurs groupes d'ancrage répondant à la formule très générale (R¹) ₐ-R²-{(R³)_{b} (R⁴)_{c}}_{d} dans laquelle R₁ peut, parmi 18 possibilités représenter -C(S)SH, aucun exemple particulier de molécule de ce type n'est mentionné.

Aucune information concernant la stabilité de la liaison de ces molécules avec la surface des nanocristaux n'est donnée.

En outre, les nanocristaux revendiqués dans le document WO-A-02/073155 sont exclusivement des nanocristaux hydrosolubles ; alors que, dans la présente invention, les ligands X-Y-Z (voir ci-dessous) confèrent aux nanocristaux des propriétés spécifiques qui ne se limitent pas à leur hydrosolubilité.

Par ailleurs, les nanocristaux revendiqués dans le document WO-A-02/073155 sont exclusivement des nanocristaux semi-conducteurs avec une coquille semi-conducteur, tandis que la présente invention concerne également les nanocristaux métalliques, les nanocristaux semi-conducteurs sans coquille et les nanocristaux avec de multiples coquilles.

Il est à noter que dans les deux derniers documents cités, les ligands qui couvrent les nanocristaux possèdent obligatoirement des fonctions hydrophiles afin de les rendre solubles dans l'eau.

Il est important de mentionner qu'il existe un grand nombre d'applications des nanocristaux, surtout en dehors du domaine du marquage biologique qui ne requièrent pas qu'ils soient hydrosolubles.

Au regard de l'étude réalisée ci-dessus, il apparaît qu'il existe un besoin pour des nanocristaux fonctionnalisés qui présentent une stabilité, notamment une stabilité colloïdale, améliorée par rapport aux nanocristaux fonctionnalisés par les ligands décrits dans les documents de l'art antérieur et surtout par rapport aux nanocristaux fonctionnalisés par des ligands thiols qui sont les plus couramment utilisés.

Il existe en outre, de manière générale, un besoin pour les nanocristaux qui possèdent une grande variété de propriétés, qui soient luminescents ou non-luminescents, solubles dans l'eau ou dans d'autres solvants et dont la structure notamment la fonctionnalisation assure une large gamme de propriétés.

Il existe en particulier un besoin pour des nanocristaux fonctionnalisés par des ligands qui présentent une photostabilité, notamment aux ultraviolets, améliorée. Dans le cas des nanocristaux photoluminescents, il existe un besoin pour des nanocristaux dont les propriétés de photoluminescence soient conservées pendant une durée prolongée.

En outre, de tels cristaux à stabilité améliorée doivent pouvoir être préparés par un procédé simple, fiable, sûr et comportant un nombre limité d'étapes. De même, les ligands doivent pouvoir être préparés par un procédé simple, fiable, flexible assurant l'accès à une grande variété de structures.

Le but de l'invention est de fournir des nanocristaux répondant entre autres aux besoins mentionnés ci-dessus et satisfaisant aux exigences et critères cités plus haut.

Le but de l'invention est encore de fournir des nanocristaux qui ne présentent pas les inconvénients, défauts, limitations et désavantages des nanocristaux de l'art antérieur et qui résolvent les problèmes posés par des nanocristaux de l'art antérieur.

Ce but, et d'autres encore, sont atteints conformément à l'invention par un nanocristal comprenant un coeur inorganique constitué par au moins un métal et/ou au moins un composé semi-conducteur comprenant au moins un métal, la surface externe dudit nanocristal étant pourvue d'une couche de revêtement organique constituée par au moins un composé ligand de formule (I) :

X-Y-Z (I)

dans laquelle :
- X représente un groupe 1,1-dithiolate ou 1,1-disélénoate qui est lié par les deux atomes de soufre ou de sélénium à un atome de métal de la surface externe dudit nanocristal ;
- Y représente un groupe espaceur, tel qu'un groupe susceptible de permettre un transfert de charge ou un groupe isolant ;
- Z est un groupe choisi parmi les groupes susceptibles de communiquer des propriétés spécifiques au nanocristal.

Les nanocristaux selon l'invention se différencient fondamentalement des nanocristaux de l'art antérieur par le fait que la couche de revêtement organique dont est pourvue la surface externe du nanocristal, que l'on peut définir comme une couche de ligands, comprend des composés ou ligands spécifiques de formule (I), dans lesquels le groupe X, qui assure la liaison du ligand avec la surface du nanocristal est, spécifiquement, selon l'invention, un groupe 1,1-dithiolate ou 1,1-disélénoate.

Ces groupes assurent une liaison forte avec la surface des nanocristaux, qu'ils soient semi-conducteurs ou métalliques.

Cette liaison est beaucoup plus forte qu'avec les ligands de l'art antérieur et notamment les ligands thiols, et les ligands multidentates tels que les dithiols. La stabilité des nanocristaux selon l'invention est en conséquence grandement améliorée par rapport aux nanocristaux fonctionnalisés stabilisés par des ligands différents.

Il apparaît que chaque molécule de ligand (I) se lie de préférence par les deux atomes de soufre ou de sélénium du groupe X sur le même atome de métal à la surface du nanocristal formant ainsi un cycle à 4 atomes et agissant comme ligand chélate bidentate.

Qu'une liaison avec une telle force, et une telle amélioration de la stabilité puissent être obtenues avec les ligands spécifiques dithiolate ou disélénoate selon l'invention ne pouvait en aucune façon être prévu au vu de l'art antérieur.

Les nanocristaux de l'invention répondent à l'ensemble des besoins énumérés plus haut et apportent une solution aux problèmes des nanocristaux de l'art antérieur, et en particulier des nanocristaux dont les ligands sont liés à la surface externe du nanocristal par des groupes thiols ou dithiols.

En d'autres termes, les principaux avantages des nanocristaux de l'invention sont, entre autres :
- une grande facilité de préparation par exemple grâce à une simple substitution des ligands déjà présents à la surface des nanocristaux par les ligands (I) caractéristiques de l'invention, du fait de la grande affinité de ces derniers pour les atomes de métal ;
- une grande stabilité colloïdale des nanocristaux couverts, enrobés par les ligands chélates (I) grâce à leur liaison forte avec les atomes de métal à la surface des nanocristaux ;
- une résistance à la photodégradation très améliorée par rapport aux nanocristaux de l'art antérieur ;
- des propriétés de photoluminescence également conservées plus longtemps qu'avec les nanocristaux de l'art antérieur et en particulier qu'avec les nanocristaux recouverts par des ligands thiols, notamment dans le cas de nanocristaux coeur/coquille.

Les propriétés des nanocristaux peuvent être facilement adaptées, modifiées grâce à la grande flexibilité qui existe dans les choix de l'espaceur Y (qui peut être conjugué ou non-conjugué, contenir ou non des hétéroatomes, etc...) et du groupement Z. Cette flexibilité provient notamment du fait que les composés ligands chélatants (I) peuvent être préparés par des voies de synthèse simple.

La fonction Z peut ainsi permettre de rendre les nanocristaux solubles dans des solvants de polarités variées tels que les hydrocarbures, les alcools, l'eau, et les mélanges de ceux-ci. En outre, la fonction Z peut permettre la liaison avec d'autres molécules telles que des molécules biologiques, des polymères conjugués, etc.

Enfin, il est à noter que les effets et avantages des nanocristaux de l'invention ne sont pas limités aux nanocristaux de semi-conducteurs A(II)/B(VI) mais sont également présentés par d'autres semi-conducteurs ou d'autres métaux, que ces cristaux soient des nanocristaux simples ou des nanocristaux coeur-coquille.

En effet, les avantages et effets des nanocristaux de l'invention sont liés de manière inhérente à la nature spécifique des composés ligands (I) et non à la nature du nanocristal ou à sa structure.

Le nanocristal pourvu d'une couche de revêtement organique constituée par les ligands (I) selon l'invention peut être un nanocristal fluorescent, photoluminescent.

Le nanocristal fluorescent photoluminescent peut avoir été soumis à une irradiation par une lumière, de préférence une lumière ultraviolette.

De manière surprenante, les cristaux luminescents, photoluminescents qui ont été soumis à une telle irradiation lumineuse, de préférence par une lumière ultraviolette présentent une efficacité, intensité de fluorescence, photoluminescence, améliorée, accrue, qui est due à un processus photochimique.

L'invention concerne, en outre, un procédé de préparation des nanocristaux tels qu'ils ont été décrits ci-dessus.

Dans une première forme de réalisation, le procédé de préparation des nanocristaux tels que décrits ci-dessus comprend les étapes successives suivantes :
a) on prépare une solution dans un solvant, de nanocristaux ayant un coeur inorganique constitué par au moins un métal et/ou au moins un composé semi-conducteur comprenant au moins un métal et éventuellement une ou plusieurs coquille(s) entourant ledit coeur, ladite (lesdites) coquille(s) étant (chacune) constituée(s) d'une couche d'un métal et/ou d'au moins un composé semi-conducteur comprenant au moins un métal, la surface externe dudit nanocristal étant pourvue d'une couche de revêtement organique constituée par au moins un premier composé ligand différent du composé ligand de formule (I) ;
b) on ajoute à la solution de l'étape a) des composés ligands de formule (I) solubles dans le solvant de ladite solution de l'étape a) de façon à ce que les composés ligands de formule (I) soient en excès par rapport aux premiers composés ligands différents du composé ligand de formule (I) dont sont pourvus les nanocristaux ;
c) on laisse en contact les composés ligands de formule (I) et les nanocristaux, de préférence sous agitation, pendant une durée suffisante pour réaliser à la surface des nanocristaux un échange essentiellement total des premiers composés ligands par les composés ligands de formule (I).

Par excès, dans l'étape b), on entend généralement que le rapport molaire des composés ligands de formule (I) ajoutés, aux premiers composés ligands est par exemple de 5 :1 à 15 :1.

Généralement, dans l'étape b), les composés de formule (I) sont ajoutés à la solution de l'étape a) sous forme d'acide HS(S)C-Y-Z ou HSe(Se)C-Y-Z, ou sous forme de sel M⁽⁺⁾ S (S) C-Y-Z ⁽⁻⁾ ou M⁽⁺⁾ Se (Se) C-Y-Z ⁽⁻⁾ avec M⁽⁺⁾ = Li⁽⁺⁾, Na⁽⁺⁾, K ⁽⁺⁾, Rb ⁽⁺⁾, Cs ⁽⁺⁾, NH₄⁽⁺⁾, PR₄ ⁽⁺⁾.

Généralement, la durée de la mise en contact de l'étape c) est de 1 à 5 heures.

Généralement, le solvant est choisi parmi le chloroforme, le dichlorométhane, le toluène, l'heptane, un autre solvant apolaire ou à faible polarité ou un mélange de ceux-ci.

Dans une seconde forme de réalisation, le procédé de préparation des nanocristaux tels que décrits ci-dessus comprend les étapes successives suivantes :
a) on prépare une solution dans un premier solvant, de nanocristaux ayant un coeur inorganique constitué par au moins un métal et/ou au moins un composé semi-conducteur comprenant au moins un métal et éventuellement une ou plusieurs coquille(s) entourant ledit coeur, ladite (lesdites) coquille(s) étant (chacune) constituée(s) d'une couche d'un métal et/ou d'au moins un composé semi-conducteur comprenant au moins un métal, la surface externe dudit nanocristal étant pourvue d'une couche de revêtement organique constituée par au moins un premier composé ligand différent du composé ligand de formule (I) ;
b) on ajoute à la solution de l'étape a) une solution des composés ligands de formule (I) dans un second solvant, lesdits composés ligands de formule (I) n'étant pas solubles dans ledit premier solvant, moyennant quoi on obtient un mélange biphasique comprenant une première phase constituée par la solution des nanocristaux dans le premier solvant et une seconde phase constituée par la solution des composés ligands de formule (I) dans le second solvant ;
c) on laisse en contact lesdites première et seconde phases, de préférence sous agitation, pendant une durée suffisante pour que les nanocristaux soient essentiellement complètement transférés dans ladite seconde phase et que soit réalisé à la surface des nanocristaux un échange essentiellement total des premiers composés ligands par les composés ligands de formule (I).

Généralement, dans l'étape b), les composés de formule (I) sont ajoutés à la solution de l'étape a) sous forme d'acide HS(S)C-Y-Z ou HSe(Se)C-Y-Z, ou sous forme de sel M⁽⁺⁾S(S)C-Y-Z⁽⁻⁾ ou M⁽⁺⁾ Se (Se) C-Y-Z ⁽⁻⁾ avec M⁽⁺⁾ = Li ⁽⁺⁾, Na ⁽⁺⁾, K ⁽⁺⁾, Rb ⁽⁺⁾, Cs⁽⁺⁾, NH₄ ⁽⁺⁾, PR₄ ⁽⁺⁾.

Généralement, la durée de mise en contact de l'étape c) est de 1 à 5 heures.

Généralement, le premier solvant est choisi parmi les solvants apolaires et les solvants de faible polarité tels que le chloroforme, le dichlorométhane, le toluène, l'heptane, l'hexane et leurs mélanges.

Généralement, le second solvant est choisi parmi les solvants polaires tels que les alcools, tel que le méthanol et l'éthanol, l'eau et leurs mélanges.

Le procédé de l'invention aussi bien dans sa première forme de réalisation que dans sa seconde forme de réalisation présente un nombre limité d'étapes simples, faciles à mettre en oeuvre, et permet une grande flexibilité dans le choix du ou des ligands dont on souhaite pouvoir recouvrir les nanocristaux.

Les réactifs utilisés sont également facilement disponibles et peuvent être aisément préparés par des réactions connues, ainsi une synthèse de Grignard permet la préparation des ligands de type acide dithiocarboxylique HS(S)C-R-Z d'une manière simple et avec de bons rendements (voir exemples 3, 4 ci-dessous) .

La plupart des autres types de ligands comme par exemple les xanthates, dithiocarbamates, etc., peut être préparée à partir des alcools, amines, phosphines, etc. qui réagissent avec le disulfure de carbone (CS₂) en présence d'une base.

Aussi bien dans sa première forme de réalisation que dans sa seconde forme de réalisation, le procédé selon l'invention peut comprendre à l'issue de l'étape c) et dans le cas où les nanocristaux sont fluorescents, photoluminescents, une étape supplémentaire au cours de laquelle les nanocristaux pourvus d'une couche de revêtement organique constitué par les ligands (I) (lesdits nanocristaux ayant été éventuellement précipités, séparés, lavés, puis séchés) sont soumis à une irradiation par une lumière, de préférence une lumière ultraviolette (UV).

En d'autres termes, les nanocristaux sont soumis à une exposition à de la lumière, de préférence de la lumière ultraviolette pendant une durée donnée, généralement de une ou quelques minutes à une ou plusieurs heures par exemple de une minute à 10 heures.

Cette irradiation, exposition, entraîne un processus photochimique qui améliore l'efficacité de la fluorescence, photoluminescence.

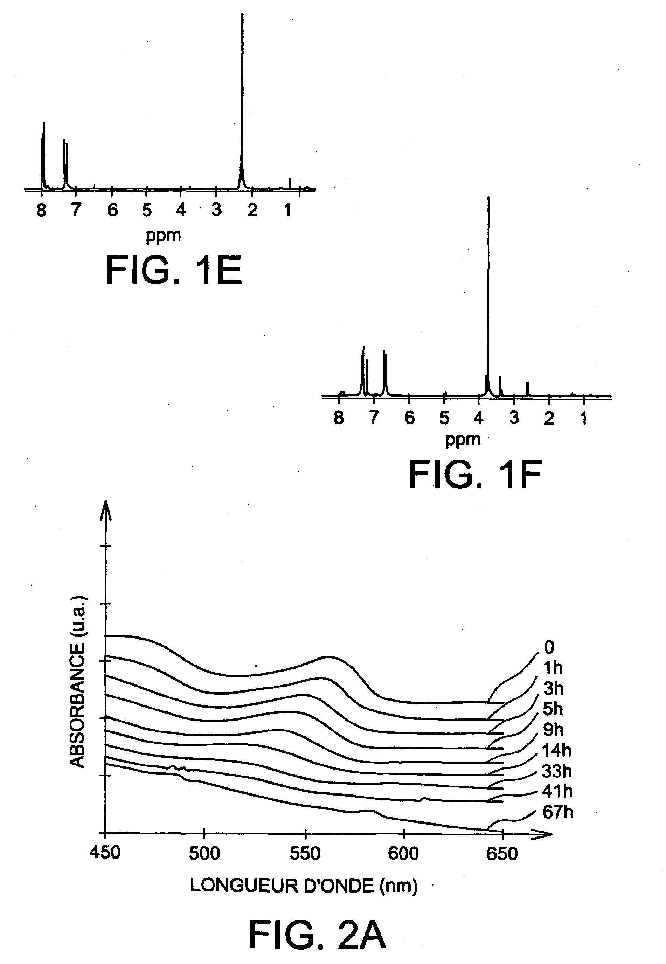

L'invention sera mieux comprise à la lecture de la description détaillée qui va suivre, donnée à titre illustratif et non limitatif, cette description étant faite en référence aux dessins joints, dans lesquels :

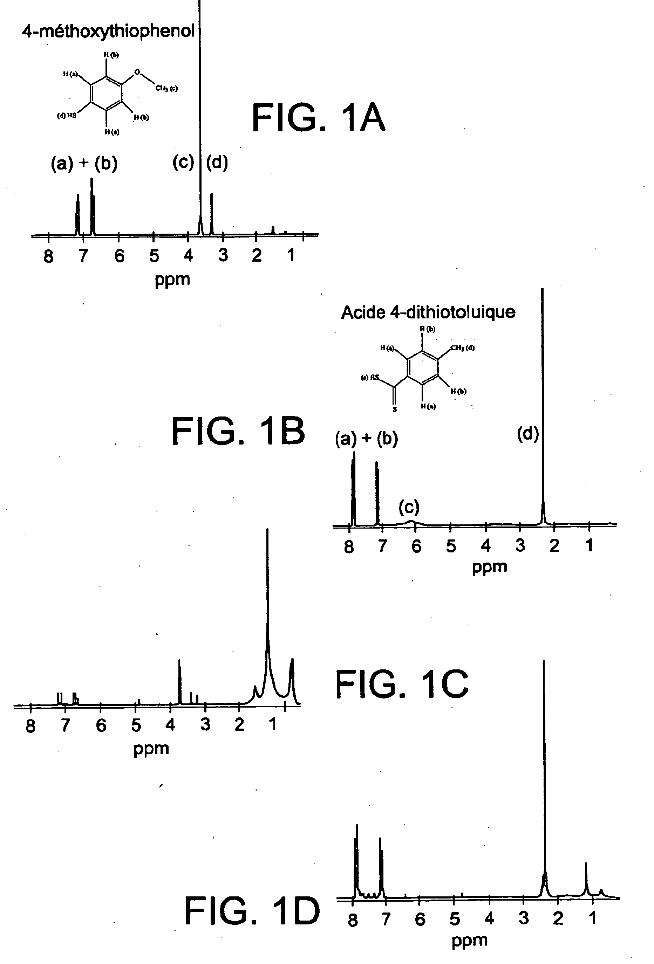

- les figures 1A à 1F représentent les spectres ¹H-RMN (200 MHz, CDCl₃) du 4-méthoxythiophénol (Fig. 1A), de l'acide 4-dithiotoluique (Fig. 1B) et de nanocristaux coeur/coquille CdSe/ZnSe (d'un diamètre d'environ 6 nm) après les réactions d'échange de ligands suivantes :
   - a) 1,5 ml d'une solution de nanocristaux (3 mg/ml) + 20 mg de 4-méthoxythiophénol (temps de réaction : 72 h) (Fig. 1C),
   - b) 1,5 ml d'une solution de nanocristaux (3 mg/ml) + 20 mg de l'acide 4-dithiotoluique (temps de réaction : 1,5 h) (Fig. 1D),
   - solution a) + 20 mg de l'acide 4-dithiotoluique (temps de réaction : 1 h) (Fig. 1E),
   - solution b) + 20 mg de 4-méthoxythiophénol (temps de réaction : 72 h) (Fig. 1F).
   Dans tous les cas, l'échange est effectué à une température de 30°C et les nanocristaux sont purifiés/séchés comme décrit dans l'exemple 5 ci-après et ensuite redispersés dans 1,5 ml de CDCl₃.
- Les figures 2A à 2C sont des graphiques représentant l'évolution des spectres d'absorption de solutions colloïdales de nanocristaux de CdSe d'un diamètre d'environ 4,5 nm, pendant une irradiation en continu à 365 nm. En ordonnée est portée l'absorbance (en unités arbitraires u.a.) et en abscisse est portée la longueur d'onde (en nm).

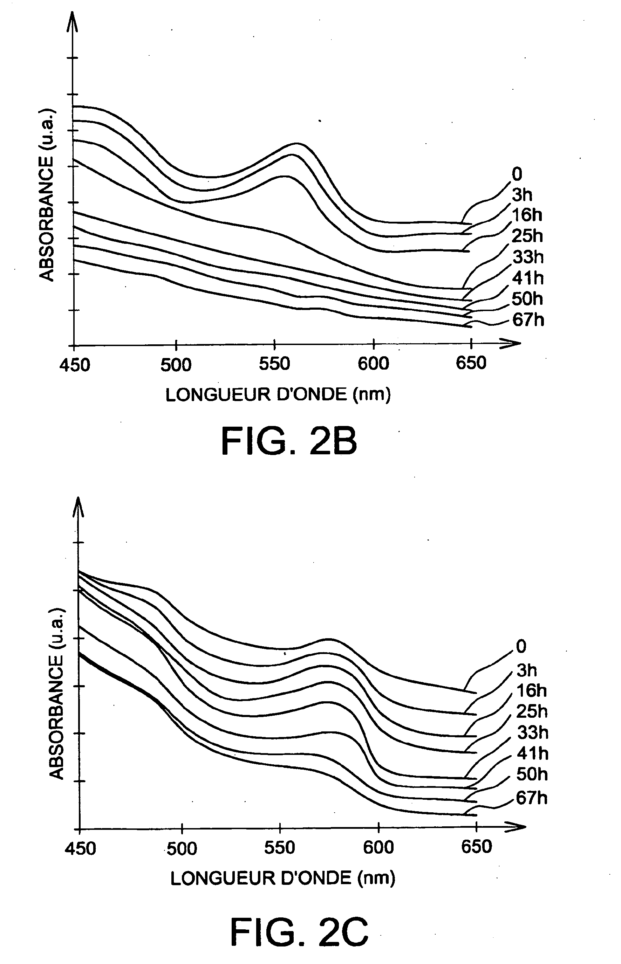

La surface des nanocristaux est couverte par des ligands différents :
- a) trioctylphosphine oxyde (TOPO)/trioctylphosphine (TOP) (issu de la synthèse) (Fig. 2A) ;
- b) après échange avec le 1-dodécanethiol (Fig. 2B) ;
- c) après échange avec l'acide 1-dithiotridécanoïque (Fig. 2C).

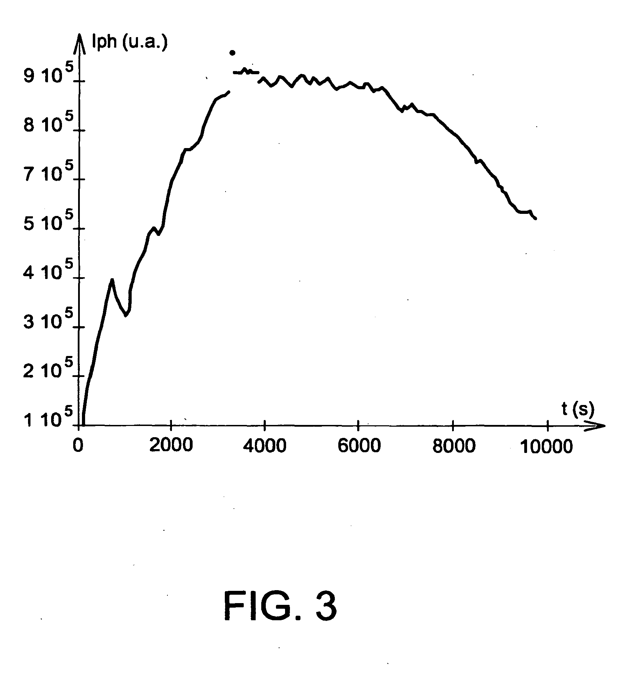

- La figure 3 est un graphique qui représente l'évolution de l'intensité de la photoluminescence d'un échantillon de nanocristaux coeur/coquille CdSe/ZnSe (conformes à l'invention et préparés conformément à l'exemple 5), dispersés dans du chloroforme, en fonction du temps d'exposition à une irradiation UV provenant d'une lampe à vapeur de mercure (365 nm, 100 W) (exemple 9).

En ordonnée est portée l'intensité de photoluminescence Iₚₕ (en unités arbitraires u.a.) et en abscisse est portée le temps (t) (en secondes).

### EXPOSÉ DÉTAILLÉ DE MODES DE RÉALISATION PARTICULIERS

Les matériaux selon l'invention sont définis comme étant des nanocristaux inorganiques à couche de revêtement organique.

Les nanocristaux inorganiques sont généralement constitués par au moins un métal et/ou au moins un composé semi-conducteur.

Les nanocristaux sont par exemple constitués par au moins un métal.

Le métal peut être quelconque, mais il est généralement choisi parmi les métaux de transition, les métaux des terres rares, les métaux des groupes IIIA, IVA et VA du tableau périodique des éléments, et leurs alliages, et les mélanges de ces métaux et alliages.

De préférence, le métal est choisi parmi l'aluminium, le cuivre, l'argent, l'or, l'indium, le fer, le platine, le nickel, le molybdène, le titane, le tungstène, l'antimoine, le palladium, le zinc, l'étain, leurs alliages, et mélanges de ces métaux et alliages.

De préférence, le métal est l'or.

Les nanocristaux peuvent être constitués par au moins un composé semi-conducteur. Le composé semi-conducteur peut être un semi-conducteur de formule AB dans laquelle A représente un métal ou un métalloïde à l'état d'oxydation +II et B représente un élément à l'état d'oxydation -II.

A est choisi généralement parmi Mg, Ca, Sr, Ba, Zn, Cd, Hg, Sn, Pb et les mélanges de ceux-ci, et B est choisi généralement parmi O, S, Se, Te et les mélanges de ceux-ci.

Des exemples de ces composés A(II)B(VI) sont MgS, MgSe, MgTe, CaS, CaSe, CaTe, SrS, SrSe, SrTe, BaS, Base, BaTe, ZnO, ZnS, ZnSe, ZnTe, CdS, CdSe, CdTe, HgS, HgSe, HgTe, SnS, SnSe, SnTe, PbS, PbSe, PbTe et les mélanges de ceux-ci.

Le composé semi-conducteur peut être aussi un semi-conducteur de formule CD (C(III) D(V)) dans laquelle C représente un métal ou un métalloïde à l'état d'oxydation +III et D représente un élément à l'état d'oxydation -III.

C est choisi généralement parmi Ga, In, et leurs mélanges, et D est choisi généralement parmi Sb, As, P, N et leurs mélanges.

Des exemples de ces composés semi-conducteurs C(III)D(V) sont GaAs, GaSb, GaN, InGaAs, InN, InGaN, InP, InAs, InSb et leurs mélanges.

Il est également possible d'utiliser des composés semi-conducteurs du groupe IV tel que le silicium ou le germanium.

On peut même utiliser un mélange des composés AB, CD et de semi-conducteurs du groupe IV.

Dans une forme de réalisation de l'invention, le nanocristal inorganique a une structure coeur/coquille(s) ("core/shell" en anglais), ledit coeur étant constitué par un nanocristal tel que décrit ci-dessus constitué d'au moins un métal et/ou au moins un composé semi-conducteur tandis que la(les) coquille(s) est(sont) chacune constituée(s) d'une couche d'un métal et/ou d'au moins un composé semi-conducteur comprenant au moins un métal.

Le coeur a par exemple un diamètre de 15 à 150 Å tandis que la (les) coquille (s) a (ont) une épaisseur de 3 à 30 Å.

Lorsque le nanocristal ne comporte pas de coquille(s), il a généralement un diamètre de 15 à 150 Å.

La couche de revêtement organique a généralement une épaisseur de 5 à 100 Å.

Toutes les combinaisons sont possibles pour les matériaux formant le coeur d'une part et la(les) coquille(s) d'autre part, mais, de préférence, le coeur est en un premier composé semi-conducteur, tandis que la coquille entourant ledit coeur (cas d'une seule coquille) ou la première coquille contenant le coeur dans le cas ou le coeur est entouré de plusieurs coquilles, est en un second composé semi-conducteur différent du premier composé semi-conducteur (formant le coeur).

Les premier et second composés semi-conducteurs sont choisis parmi les composés semi-conducteurs déjà décrits plus haut.

De préférence, le coeur est en un premier composé semi-conducteur de type A(II)B(VI) décrit plus haut, tel que CdSe, tandis que la coquille entourant le coeur ou la première coquille entourant le coeur, est en un second composé semi-conducteur de type A(II)B(VI) différent du premier composé semi-conducteur choisi par exemple parmi znSe, ZnS et CdS.

Dans le cas des multiples coquilles, deux coquilles successives sont généralement en des composés semi-conducteurs différents.

Ainsi, dans le cas des multiples coquilles, les matériaux formant les coquilles peuvent être choisis parmi toutes les combinaisons possibles des composés cités précédemment par exemple ces composés peuvent être choisis parmi ZnSe, CdS et ZnS. Par exemple, on pourra avoir une première coquille en ZnSe ou en CdS et une deuxième coquille en ZnS.

Selon l'invention, la couche externe de nanocristal inorganique est revêtue d'une couche de revêtement organique constituée par des ligands spécifiques répondant à la formule générale (I) :

(I) X-Y-Z

De manière fondamentale, selon l'invention, comme on l'a déjà indiqué plus haut le groupe X que l'on peut aussi nommé groupe d'ancrage est un groupe 1,1-dithiolate (-C (S) S⁻) ou un groupe 1,1-disélénoate (-C (Se) Se⁻) .

L'essentiel des propriétés avantageuses des nanocristaux de l'invention est dû à ce groupe X particulier.

Le groupe Y ou groupe espaceur peut être choisi parmi une grande variété de groupes, qui peuvent permettre un transfert de charge ou bien être isolants.

Y répond généralement à la formule suivante :

-R₁-R- (II)

où R₁ représente :
- une liaison simple ;
- un groupe 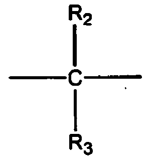 où R₂ et R₃ représentent indépendamment un hydrogène, un radical alkyle, un radical aryle, un radical alcoxy, un halogène ;
- un groupe 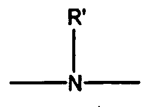 où R' représente un hydrogène, un radical alkyle, un radical aryle, un radical alcoxy, un halogène ;
- un groupe 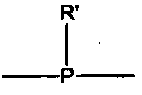 où R' a la signification déjà donnée plus haut ;
- un groupe 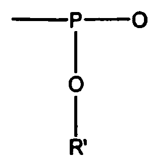 où R' a la signification déjà donnée plus haut ;
- -O- ;
- -S- ;
- -Se- ;
et R représente un groupe alkylène linéaire ou ramifié ayant de 1 à 30 atomes de carbone, de préférence de 1 à 8 ; un ou plusieurs atomes de carbone dudit groupe alkylène étant éventuellement remplacés par un ou plusieurs hétéroatomes choisis parmi O, N, S, P et Si ; ledit groupe alkylène comprenant en outre éventuellement une ou plusieurs doubles et/ou triples liaisons telles que des doubles et/ou triples liaisons carbone-carbone ; et ledit groupe alkylène étant en outre éventuellement substitué par un ou plusieurs groupes choisis parmi les halogènes, tels que le chlore, le brome, l'iode et le fluor, les hétérocycles, les radicaux aryle, hydroxyle, alcoxy, amino, acyle, carboxamido ; =O, -CHO, -CO₂H, -SO₃H, -PO₃H₂, -PO₄H₂, -NHSO₃H, sulfonamide ; monoalkylamino, trialkylammonium, ou bien encore par un radical dialkylamino, dans lequel les deux groupements alkyle peuvent former, conjointement avec l'atome d'azote dudit groupement dialkyl(C₁-C₄)amino, auquel ils sont liés, un cycle pouvant être interrompu par un ou plusieurs atomes d'azote, d'oxygène ou de soufre, et les groupes Z ; ou R représente un hétérocycle, un radical aryle, un radical aryle condensé sur un ou plusieurs autres cycles aryles et/ou cycles alkyles ou hétérocycles, un radical cycloalkyle, un radical cycloalkyl-alkyle, un radical alkyl-cycloalkyle, un radical arylalkyle, un radical alkylaryle, un radical hétérocycloalkyle, un radical alkyl-hétérocycloalkyle.

Selon l'invention, le terme alkyle pour les radicaux alkyle, ainsi que pour les groupements comportant une partie alkyle, signifie, sauf indication différente, une chaîne carbonée, linéaire ou ramifiée, comportant de 1 à 30 atomes de carbone, de préférence de 1 à 8, pouvant être portée et/ou interrompue par un ou plusieurs atomes d'oxygène, de soufre, d'azote, de phosphore ou de silicium et pouvant en outre être substituée par un ou plusieurs groupes choisis parmi les atomes d'halogène, tel le chlore, le brome, l'iode et le fluor ; les hétérocycles ; les radicaux aryle ; hydroxyle ; alcoxy ; amino ; acyle ; carboxamido ; =O ; -CHO ; -CO₂H ; -SO₃H ; -PO₃H₂ ; -PO₄H₂ ; -NHSO₃H ; sulfonamide ; monoalkylamino ; trialkylammonium ; ou bien encore par un radical dialkylamino, dans lequel les deux groupements alkyle peuvent former, conjointement avec l'atome d'azote dudit groupement dialkyl(C₁-C₄)amino, auquel ils sont liés, un cycle pouvant être interrompu par un ou plusieurs atomes d'azote, d'oxygène ou de soufre.

Selon l'invention le terme alcoxy utilisé pour les radicaux alcoxy ainsi que pour les groupements comportant une partie alcoxy, signifie, sauf indication différente, une chaîne O-alkyle, le terme alkyle ayant la signification indiquée ci-dessus. Les radicaux alcoxy des groupes alcoxycarbonyle ont, de préférence, de 1 à 4 atomes de carbone. Les groupes acyle ont, de préférence, de 2 à 4 atomes de carbone.

Selon l'invention, on entend par hétérocycle, un cycle aromatique ou non contenant 5, 6 ou 7 sommets, et de 1 à 3 hétéroatomes choisis parmi les atomes d'azote, de soufre et d'oxygène. Ces hétérocycles peuvent être condensés sur d'autres hétérocycles, ou sur d'autres cycles notamment aromatiques tels qu'un groupement phényle. Ces hétérocycles peuvent, en outre, être quaternisés par un radical alkyle. Les termes alkyle et alcoxy ont les significations indiqués ci-dessus.

Parmi, les hétérocycles, on peut notamment citer à titre d'exemple les cycles : thiophène, benzothiophène, furane, benzofurane, indole, indoline, carbazole, pyridine, déhydroquinoléine, chromone, julodinine, thiadiazole, triazole, isoxazole, oxazole, thiazole, isothiazole, imidazole, pyrazole, triazine, thiazine, pyrazine, pyridazine, pyrimidine, pyridine, diazépine, oxazépine, benzotriazole, benzoxazole, benzimidazole, benzothiazole, morpholine, pipéridine, pipérazine, azétidine, pyrrolidine, aziridine.

Selon l'invention, on entend par cycloalkyle, un radical ayant de 3 à 10, de préférence de 4 à 8 C éventuellement substitué par un ou plusieurs groupes tels que définis ci-dessus. Des exemples de radicaux cycloalkyle sont cyclobutyle, cyclopentyle et cyclohexyle.

Selon l'invention, on entend par aryle, sauf spécifié autrement, un radical aryle en C₆ à C₃₀ pouvant être substitué par un ou plusieurs radicaux alkyle de 1 à 18 C ; alcoxy ; acyle ; cyano ; carboxamido ; =O ; -CHO ; -CO₂H ; -SO₃H ; -PO₃H₂ ; -PO₄H₂ ; hydroxyle ; amino ; monoalkyl (C₁-C₄) amino ; ou dialkyl (C₁-C₄) amino ; dans lequel les deux groupements alkyle peuvent former, conjointement avec l'atome d'azote dudit groupement dialkyl(C₁-C₄)amino, auquel ils sont liés, un cycle pouvant être interrompu par un ou plusieurs atomes d'azote, d'oxygène ou de soufre. De préférence, le groupe aryle est un groupe phényle ou un groupe naphtyle pouvant être substitué comme indiqué ci-dessus.

R₁, R₂ et R₃ peuvent en outre porter un ou plusieurs autres groupes Z.

Des groupes Y préférés sont les chaînes alkylènes - (CH₂)ₙ- avec n = 1 à 18, de préférence n = 12, les cycles aromatiques éventuellement substitués tels que : 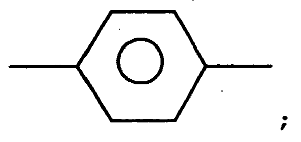 et les chaînes alcoxy -[(CH₂)ₘO(CH₂)ₘ]ₙ-, avec m = 1 à 4, et n = 1 à 6.

Selon sa structure chimique, le groupe Y ou groupe espaceur peut influencer les propriétés électroniques du ligand X-Y-Z ainsi que la stabilité et la solubilité du nanocristal recouvert par ces ligands.

Par exemple, un groupe Y constitué par un cycle aromatique -C₆H₄- peut permettre un transfert électronique à travers le ligand X-Y-Z, tandis qu'un groupe Y constitué par une chaîne alkylène longue telle que -C₁₂H₂₄- peut empêcher ce transfert électronique. Une chaîne Y de type polyéther telle que - (CH₂) ₂-O- (CH₂) ₂-O- (CH₂) ₂- peut augmenter la solubilité des nanocristaux en milieu polaire par rapport à des ligands où Y ne contient pas d'hétéroatomes tels que l'oxygène. Par ailleurs, en fonction de sa structure chimique, l'espaceur Y peut porter une ou plusieurs fonctions Z identiques ou différentes.

Le groupe Z peut être quelconque, mais il est généralement choisi afin d'obtenir des propriétés spécifiques, comme par exemple une solubilité des nanocristaux dans un solvant spécifique défini par une polarité donnée.

Le groupe Z peut donc être choisi parmi les groupes qui permettent la solubilisation des nanocristaux dans des solvants apolaires et/ou des solvants à faible polarité, tels que les hydrocarbures ; ou bien le groupe Z peut être choisi parmi les groupes qui permettent la solubilisation des nanocristaux dans les solvants polaires tels que l'eau, les alcools et leurs mélanges.

Le groupe Z, outre le fait de permettre la solubilité de nanocristaux dans les solvants à polarité donnée, peut aussi permettre la liaison des nanocristaux avec d'autres molécules telles que les molécules biologiques, les polymères et oligomères conjugués et autres, et/ou bien le groupe Z peut déjà contenir des polymères ou oligomères conjugués ou des molécules biologiques.

En outre, le groupe Z peut permettre la liaison entre des nanocristaux (c'est-à-dire la liaison du nanocristal avec un ou plusieurs autres nanocristaux).

Le groupe Z peut donc être choisi parmi les groupes qui permettent la liaison des nanocristaux avec d'autres molécules.

Avantageusement, le groupe Z est choisi parmi les groupes hydrophiles, en particulier les groupes polaires, tels que les groupes hydroxyles, les groupes formyles, les alcoxydes, les acides carboxyliques, les amines, les polyéthers, tels que le polyéthylèneglycol, et les groupes chargés tels que les groupes carboxylates, les sulfonates, les phosphates, les nitrates, les sels d'ammonium et analogues.

Z peut également être identique à X permettant ainsi la liaison entre des nanocristaux.

Z peut aussi être simplement un atome d'hydrogène.

Des groupes Z préférés entre tous sont les suivants : hydroxyle (-OH) pour permettre une dispersion des nanocristaux dans des solvants polaires ; formyle (-CHO) et acide carboxylique (-COOH) pour permettre la liaison des nanocristaux avec d'autres molécules.

Plusieurs groupes Z identiques ou différents peuvent être présents sur le même ligand qui possède alors une formule de type : 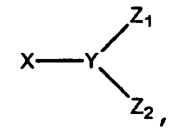 où Z₁ et Z₂ identiques ou différents ont la signification déjà donnée pour Z.

En outre, plusieurs groupes X peuvent être présents sur le même ligand qui possède alors par exemple une formule de type : 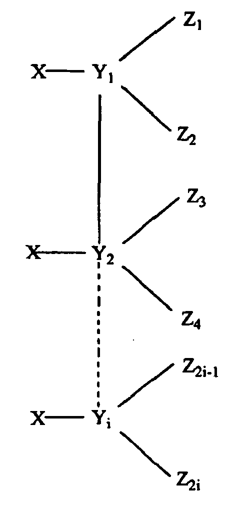 où Y₁, Y₂, Yᵢ identiques ou différents et Z₁, Z₂, Z₃, Z₄, Z₂ᵢ₋₁, Z₂ᵢ identiques ou différents ont la signification déjà donnée précédemment pour Z et Y.

En outre, plusieurs ligands qui différent par le ou les groupes Y et/ou Z qu'ils contiennent peuvent se trouver sur le même nanocristal, ce qui permet de communiquer à ce nanocristal toutes les propriétés voulues et d'adapter "sur mesure" ces propriétés en fonction du milieu de dissolution et de l'application recherchée.

Ainsi, on pourra introduire sur le nanocristal à la fois des ligands qui assurent la solubilité des nanocristaux dans un solvant donné et des ligands qui présentent des fonctions permettant la liaison avec d'autres molécules, ou bien encore les mêmes ligands peuvent porter des fonctions assurant la solubilité dans un solvant donné et des fonctions permettant la liaison avec d'autres molécules.

Grâce au procédé de préparation des nanocristaux, il est très facile de contrôler, d'ajuster, le nombre de fonctions d'une catégorie par rapport à une autre en changeant le rapport des deux ligands pendant la fonctionnalisation des nanocristaux.

Les nanocristaux selon l'invention, pourvus d'une couche de revêtement organique constitué par les ligands (I), peuvent être des nanocristaux fluorescents, photoluminescents.

L'homme du métier peut facilement choisir la nature du coeur organique, et/ou de la coquille et/ou des ligands (I) pour faire en sorte que le nanocristal selon l'invention soit fluorescent, photoluminescent.

Lorsque les nanocristaux sont fluorescents, luminescents, en d'autres termes lorsque l'application recherchée des nanocristaux repose sur leur fluorescence, photoluminescence, ils peuvent être soumis à une irradiation par une lumière, de préférence une lumière ultraviolette qui améliore, accroît, l'efficacité, l'intensité, de fluorescence, photoluminescence, en conséquence d'un processus photochimique.

Le procédé de préparation des nanocristaux selon l'invention va maintenant être décrit.

Dans une première étape, on prépare un nanocristal inorganique, à structure simple "coeur" ou bien à structure "coeur-coquille" à la surface duquel sera ensuite fixée la couche de revêtement, de ligands organiques selon l'invention.

Tout procédé connu peut être utilisé pour synthétiser les nanocristaux.

Cependant, un procédé préféré est celui décrit dans le document FR-A-2 838 241 déjà mentionné plus haut et qui permet la préparation de nanocristaux en semi-conducteur de formule AB où A est un métal ou un métalloïde à l'état d'oxydation +II et B représente un élément chimique à l'état d'oxydation -II.

Dans ce procédé, afin de synthétiser les nanocristaux de semi-conducteur AB, on commence par faire réagir un oxyde de A avec une poudre de B.

On choisit, en tant que réactif spécifique un oxyde de A, tel que CdO, ou HgO, car un tel réactif oxyde, par exemple CdO, s'avère moins réactif et plus facile d'usage que les composés de dialkyl métal, par exemple, tels que les composés de dialkylcadmium couramment utilisés dans d'autres procédés.

Il est généralement nécessaire de complexer l'oxyde de A, tel que CdO, avec un acide alkylphosphonique.

Divers acides alkylphosphoniques à haut point d'ébullition peuvent, en principe, être utilisés comme agents complexants, de tels acides répondent, par exemple, à la formule : 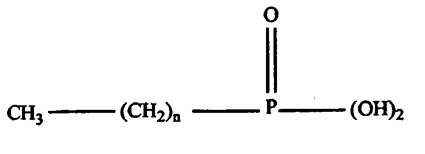 où n est un entier de 5 à 15.

Le complexant préféré est l'acide dodécylphosphonique (DDPA).

La poudre de B est le second réactif spécifique de ce procédé. Il pourra s'agir, de préférence, d'une poudre de Se, de Te, ou de S, Se étant préféré. Ce réactif est généralement dissout dans de la trialkylphosphine, dont le groupe alkyle a de 4 à 12 atomes de carbone, le trialkylphosphine préféré étant la trioctylphosphine. La concentration de poudre de B dans le trialkylphosphine est généralement de 0,1 M à 0,5 M.

La réaction a lieu selon ce procédé dans un solvant spécifique constitué d'un mélange d'au moins un trialkylphosphine oxyde et d'au moins une alkylamine primaire.

L'alkylamine primaire est généralement choisie parmi les amines primaires à longue chaîne, c'est-à-dire comportant de 6 à 24, de préférence 14 à 24 atomes de carbone, et à haut point d'ébullition, l'amine, encore préférée, est l'hexadécylamine (HDA).

Le trialkylphosphine oxyde est choisie généralement parmi les trialkylphosphines oxydes dont le groupe alkyle comprend de 4 à 12 atomes de carbone, le trioctylphosphine oxyde (TOPO) étant préféré.

Il a été constaté que la concentration molaire relative de chacun des composés entrant dans le mélange de solvant influençait la cinétique de croissance et la distribution de taille des nanocristaux, le mélange comporte donc généralement de 50 à 90% en moles d'alkylamine, par exemple de HDA.

Une concentration molaire préférée est de 60 à 80% en moles d'alkylamine, par exemple de HDA.

Lors d'une mise en oeuvre typique de ce procédé, le mélange solvant, par exemple de TOPO/HDA et l'oxyde, par exemple, le CdO, sont chauffés dans un ballon au-dessus de la température de fusion des solvants, cette température est donc généralement supérieure à 60°C, de préférence de 150 à 250°C.

L'agent complexant, tel que le DDPA, est alors ajouté, puis la température augmentée jusqu'à environ 260-300°C. Durant ce chauffage, la poudre d'oxyde, tel que le CdO, se dissout et une solution incolore et transparente, dans le cas du CdO, se forme.

La température de la réaction de complexation dépend fortement des quantités relatives des deux composés formant le solvant, par exemple la HDA et le TOPO, et décroît lorsque la concentration relative en trialkylphosphine oxyde, par exemple en TOPO, augmente.

La solution de B, par exemple de Se, dans la trialkylphosphine, par exemple la TOP, est préparée séparément à température ambiante, puis très rapidement injectée dans le ballon. La température du mélange réactif dans le ballon pendant l'injection est d'une importance cruciale. Elle doit, de préférence, se situer entre 240 et 300°C.

Il faut noter ici que la température du mélange réactif influe fortement sur la nucléation et la croissance de nanocristaux. En général, pour des temps de réaction similaires, de plus petits nanocristaux sont formés aux températures faibles. Pour une température donnée, la taille finale des nanocristaux est déterminée par le temps de réaction. Le temps de réaction est, par exemple, de 2 à 90 minutes.

La réaction peut être arrêtée à tout moment par refroidissement du mélange réactif pour obtenir un échantillon de nanocristaux à la taille souhaitée. Les nanocristaux sont alors précipités par l'ajout d'un mélange adéquat, par exemple de méthanol et de n-butanol, puis séparés, par exemple, par centrifugation et purifiés.

Il faut ajouter que ce procédé décrit ci-dessus, assure une meilleure qualité des nanocristaux coeur que d'autres procédés.

Ceci est dû à une distribution de taille très étroite, ce qui est un avantage important de ce procédé. Dans les procédés de l'art antérieur, une étape - coûteuse en matériau - de tri des nanocristaux en fractions de taille donnée, doit impérativement être utilisée pour obtenir des échantillons dont la largeur de la distribution de taille est aussi étroite que celle que procure directement le procédé de l'invention, à savoir inférieur à 5%.

Le procédé décrit dans le document FR-A-2 838 241 a l'avantage de ne pas comporter d'étape de tri des nanocristaux en fractions de tailles données (fractionnement) et est considérablement plus simple que d'autres procédés.

A l'issue de la préparation des nanocristaux de semi-conducteur, on peut éventuellement effectuer sur ces derniers la synthèse, la croissance d'une coquille qui est par exemple en ZnSe.

Le couple coeur/coquille (CdSe/ZnSe) constitue, selon ce document, l'un des meilleurs choix, voire le meilleur choix possible pour les composés A(II)B(VI) .

Deux types de précurseurs du zinc peuvent être choisis pour la préparation d'une coquille en ZnSe : l'oxyde de zinc (ZnO) et un carboxylate de zinc de formule générale :

Zn(RₐCOO)₂

où Rₐ représente un groupe alkyle aliphatique de 1 à 24 atomes de carbone, le carboxylate de zinc préféré est le stéarate de zinc de formule :

[CH₃ (CH₂)₁₆CO₂]₂Zn.

L'avantage lié à leur usage provient notamment du fait que ce sont des composés produits industriellement, peu coûteux, et bien plus faciles à manipuler que les composés dialkyl zinc.

Dans le cas de ZnO, la complexation par un acide alkylphosphonique, déjà décrit plus haut, est requise, comme pour la préparation du coeur, à partir, par exemple, de CdO.

ZnO est complexé, par exemple, par de l'acide dodécylphosphonique (DDPA) dans du trialkylphosphine oxyde, par exemple du TOPO entre 350 et 360°C.

La solution incolore obtenue est diluée à une concentration de 0,1 M à 0,5 M, par exemple à environ 60°C dans une petite quantité de toluène ou de tout autre solvant, par exemple, permettant l'amélioration de ses propriétés rhéologiques.

L'utilisation d'un carboxylate de zinc, tel que le stéarate de zinc, est encore plus simple, puisque le produit est simplement dilué dans un solvant approprié, tel que le toluène, sans étape de complexation.

La source de sélénium est la même que pour la préparation du coeur : de la poudre de sélénium dissoute dans une trialkylphosphine, de préférence dans la TOP. Cette solution est mélangée à température ambiante avec la solution contenant la source de zinc (oxyde ou carboxylate). Le mélange résultant peut être aisément injecté à l'aide d'une seringue, en outre, dans le ballon où a lieu la synthèse.

Pour la croissance de la coquille, l'injection a lieu dans un solvant constitué d'un mélange d'au moins un trialkylphosphine oxyde et d'au moins une alkylamine primaire, le mélange préféré étant constitué d'un mélange de TOPO et de HDA. Le mélange de solvants, par exemple TOPO/HDA, contient une dispersion de nanocristaux coeur, par exemple en CdSe.

La température de ce mélange est de première importance. Trop basse, aucune réaction de croissance cristalline de ZnSe n'a lieu. A l'inverse, si cette température est trop haute, des germes cristallins de ZnSe se forment et des nanocristaux de ZnSe apparaissent à la place de la croissance épitaxiale de ZnSe sur les coeurs, par exemple en CdSe. De plus, une température trop élevée peut entraîner un élargissement de la distribution de taille des nanocristaux, par exemple de CdSe, par le fait d'un échange de matière entre les nanocristaux par dissolution, puis redépôt. Dans ce contexte, l'utilisation d'un mélange solvant trialkylphosphine oxyde/alkylamine primaire, par exemple TOPO/HDA, avec un taux élevé de HDA, à savoir de 50 à 80% en moles, joue un rôle crucial. La HDA est moins fortement liée au Zn que le TOPO, permettant ainsi la formation de la coquille à des températures plus basses. De plus, grâce à une gêne stérique moins importante, la HDA assure une meilleure passivation chimique de la surface que le TOPO (ou le TOPSe), en particulier pour les plus grandes tailles des systèmes coeur/coquille, présentant la surface de plus faible courbure.

Cependant, une alkylamine, telle que la HDA pure n'est pas un solvant adapté pour la croissance de la coquille.

Les meilleurs résultats sont donc obtenus avec un mélange solvant constitué, de préférence de 60 à 80% d'alkylamine, de préférence de HDA, soit 40 à 20% de trialkylphosphine oxyde TOPO, en fractions molaires.

La présence de la HDA sur la surface de la coquille peut être déterminée quantitativement par la mesure des spectres ¹H-RMN (200 MHz, CDCl₃) des nanocristaux, par exemple, CdSe/ZnSe préparés par le procédé de l'invention, grâce au pic des protons α-CH₂ de la chaîne alkyl de la HDA.

Finalement, le choix de la température dépend de la taille des nanocristaux coeur, par exemple en CdSe, utilisés pour la synthèse. Dans l'immense majorité des cas, la température est dans l'intervalle 170-210°C, les valeurs les plus élevées étant utilisées pour les plus gros nanocristaux coeur. Comme la formation de germes de ZnSe est facilitée par une concentration élevée des précurseurs de zinc et de sélénium, l'injection de leur solution doit, de préférence, être extrêmement lente, avec une vitesse constante, par exemple de 3 à 10 ml par heure pour un volume total de 5 ml à injecter.

On utilisera, à cette fin, de préférence, un système commercial de microinjection automatisé de type pousse-seringue.

Lorsque l'addition des précurseurs de ZnSe est terminée, le mélange réactionnel est conservé à la température de synthèse durant une durée, par exemple de une à deux heures, pour permettre le « recuit » des coquilles et améliorer leur qualité cristalline. Ce mélange est ensuite refroidi, par exemple, jusqu'à environ 60°C.

Les étapes de précipitation par un mélange, par exemple méthanol/n-butanol de séparation et de purification sont ensuite conduites exactement de la même façon que pour la préparation des nanocristaux coeur.

La largeur à mi-hauteur de la raie d'émission pour les nanocristaux coeur, par exemple, en CdSe, comme pour les coeur/coquille, par exemple, CdSe/ZnSe est extrêmement étroite, typiquement 25 à 30 nm, tels que synthétisés, sans aucune procédure de tri en taille.

Le rendement quantique de fluorescence à température ambiante des nanocristaux coeur/coquille semi-conducteurs A(II)B(VI) ainsi préparés est très élevé. Il excède 60%, voire dans certains cas 80%.

A l'issue de ce procédé, on obtient des nanocristaux comprenant un coeur éventuellement entouré d'une coquille, ledit coeur étant constitué par un nanocristal en semi-conducteur de formule AB dans laquelle A représente un métal ou un métalloïde à l'état d'oxydation +II (Cd, Hg) et B représente un élément chimique, tel qu'un métal ou un métalloïde, à l'état d'oxydation -II (Se, S, Te) et la coquille est constituée par exemple d'une couche de ZnSe, la surface des nanocristaux étant pourvue d'une couche de passivation organique constituée d'au moins une amine primaire telle que l'hexadécylamine (HDA) associée à au moins un composé phosphine oxyde tel que le trioctylphosphine oxyde (TOPO) et/ou phosphine séléniure tel que le triocthylphosphine séléniure (TOPSe).

Le nanocristal inorganique obtenu à l'issue de la première étape, comprend généralement du fait même du procédé de préparation utilisé pour le préparer, une couche de revêtement organique constituée de ligands qui sont différents des ligands spécifiques de formule (I) selon l'invention.

Il s'agit généralement de ligands choisis parmi les phosphine oxydes tels que les trialkylphosphine oxyde dont le groupe alkyle comprend de 4 à 12 atomes de carbone tel que le trioctylphosphine oxyde (TOPO) ; les séléniures de phosphines tels que les séléniures de trialkylphosphines dont le groupe alkyle comprend de 4 à 12 atomes de carbone, tel que le séléniure de trioctylphosphine (TOPSe) ; les trialkylphosphines tels que les trialkylphosphines dont le groupe alkyle comprend de 4 à 12 atomes de carbone tel que la trioctylphosphine (TOP) ; les amines primaires telles que les alkylamines dont le groupe alkyle comprend de 6 à 24 atomes de carbone telle que l'hexadécylamine (HDA) ; et les acides carboxyliques tels que l'acide stéarique ; et les mélanges de ceux-ci.

Dans une deuxième étape, afin de préparer le nanocristal selon l'invention, on met en solution des nanocristaux préparés plus haut et qui comprennent à leur surface externe une couche de revêtement constituée par un ou plusieurs ligands différents des ligands de formule (I) spécifiques aux nanocristaux selon l'invention, dans un solvant.

Dans une première forme de réalisation de la deuxième étape, les ligands (I) sous forme d'acide HS(S)C-Y-Z ou HSe(Se)C-Y-Z, selon l'invention, sont solubles dans le même solvant que celui utilisé pour préparer la solution de nanocristaux décrits ci-dessus (solution dite de nanocristaux "avant l'échange"), par exemple du chloroforme, le dichlorométhane, le toluène, l'heptane, un autre solvant apolaire, ou à faible polarité, ou un mélange de ceux-ci.

Il est à noter que dans l'ensemble de la description, on utilise le terme "ligand" pour désigner indifféremment la molécule organique fixée sur la surface externe du nanocristal qui est un dithiolate ou un disélénoate et la molécule organique correspondante en solution qui se trouve alors sous sa forme d'acide dithiocarboxylique ou d'acide disélénocarboxylique.

L'échange des molécules à la surface des nanocristaux par ces nouveaux ligands dithiolate ou disélénoate selon l'invention de formule (I) se fait simplement en ajoutant les nouveaux ligands de formule (I) à la solution de nanocristaux issus de la première étape de façon à obtenir dans la solution un excès (à savoir un rapport molaire de 5 :1 à 15 :1 par exemple) de ces nouveaux ligands (I) par rapport aux ligands présents sur les nanocristaux.

On obtient un échange total complet des ligands initialement présents, par les ligands (I) en une durée généralement de 1 à 5 heures sous agitation à température ambiante (25-30°C).

On fait ensuite, généralement, précipiter les nanocristaux pourvus d'une couche de revêtement organique constitué par les ligands (I) en ajoutant à la solution de nanocristaux un solvant ou un mélange de solvants ayant une polarité différente. Ces solvants sont généralement choisis parmi le méthanol, l'éthanol, le propanol, le butanol ou d'autres solvants polaires.

Eventuellement, les nanocristaux sont ensuite généralement séparés, par exemple par filtration, puis ils sont généralement lavés, rincés de 1 à 4 fois avec le même solvant qui a servi à la précipitation. Les nanocristaux sont ensuite généralement séchés par exemple pendant une durée de 1 à 5h, de préférence sous vide, à une température de 20 à 60°C.

Une seconde forme de réalisation de la deuxième étape est mise en oeuvre notamment dans le cas où les nouveaux ligands ne sont solubles que dans les solvants trop polaires pour disperser les nanocristaux tels que les alcools tels que le méthanol, l'éthanol, etc., ou l'eau et leurs mélanges.

Ceci est notamment le cas en utilisant les ligands (I) sous forme de sel de formules M⁽⁺⁾ S (S) C-Y-Z⁽⁻⁾ ou M⁽⁺⁾ Se (Se) C-Y-Z ⁽⁻⁾ dans lesquelles M⁽⁺⁾ est généralement choisi parmi Li⁽⁺⁾, Na⁽⁺⁾ , K⁽⁺⁾, Rb⁽⁺⁾, Cs ⁽⁺⁾, NH₄ ⁽⁺⁾, et PH₄⁽⁺⁾.

On réalise alors un échange hétérogène biphasique dans lequel la phase de nanocristaux (avec les "anciens" ligands) dans un solvant de préférence apolaire tel que le chloroforme et la phase du nouveau ligand (I) (dans un solvant polaire tel que le méthanol ou l'eau) sont mises en contact intime, de préférence sous forte agitation, jusqu'au transfert complet des nanocristaux dans la phase polaire.

Généralement, on peut précipiter, on peut séparer, on peut laver, et on peut sécher, les nanocristaux recouverts de ligands (I) de la même manière que dans la première forme de réalisation. Mais le solvant utilisé pour la précipitation et le rinçage, lavage, est cette fois un solvant apolaire choisi par exemple parmi les solvants heptane, hexane ou toluène.

A l'issue de l'étape c) aussi bien dans la première que dans la seconde forme de réalisation, les nanocristaux pourvus d'une couche de revêtement organique constituée par les ligands (I), éventuellement précipités, séparés, lavés, puis séchés, sont soumis à une irradiation par une lumière, de préférence une lumière ultraviolette, par exemple une lumière UV d'une longueur d'onde de 365 nm.

Cette irradiation est réalisée dans le cas où les nanocristaux pourvus d'un revêtement organique constitué par les ligands (I) sont des nanocristaux fluorescents, photoluminescents.

En d'autres termes, dans le cas où on utilise des nanocristaux fluorescents, photoluminescents, ces derniers peuvent être, suite à l'étape c), et éventuellement aux étapes de précipitation, séparation, lavage (rinçage) et séchage, soumis à un traitement photochimique, afin d'augmenter, d'améliorer, l'efficacité, l'intensité de leur fluorescence, photoluminescence. Cette irradiation est réalisée de préférence en dispersant les nanocristaux pourvus d'une couche de revêtement organique constituée par les ligands (I) dans un solvant approprié, et en exposant les nanocristaux à une irradiation lumineuse, de préférence à de la lumière ultraviolette.

Ledit solvant pour la mise en dispersion peut être choisi parmi les solvants apolaires et les solvants de faible polarité tels que le chloroforme, le dichlorométhane, le toluène, l'heptane, l'hexane, et leurs mélanges ; ou parmi les solvants polaires tels que les alcools, l'eau, et leurs mélanges.

Le temps d'irradiation nécessaire pour obtenir une fluorescence maximale de l'échantillon peut aller de 1 ou quelques minutes à 1 ou plusieurs heures, par exemple 10 heures, il est notamment de 1 heure.

Ce temps d'irradiation peut varier selon les conditions expérimentales telles que les spécifications de la source lumineuse, la distance entre la source et l'échantillon de nanocristaux, la concentration de l'échantillon (lorsqu'on irradie une dispersion de nanocristaux dans un solvant), ce temps peut être déterminé par spectroscopie de photoluminescence.

Plus précisément, le temps, la durée de l'irradiation, notamment par de la lumière UV est généralement de 1 minute à 10 heures, de préférence de 10 minutes à 200 minutes, de préférence encore de 50 à 100 minutes, par exemple de 60 minutes.

A titre d'exemple, on place l'échantillon de nanocristaux, de préférence en suspension dans un solvant tel que le chloroforme, dans une cuvette en quartz à une distance de 3 à 5 cm d'une lampe à mercure de 100 W qui émet à 365 nm ; et on expose l'échantillon à une irradiation pendant une heure (cf. Fig. 3).

L'invention va maintenant être décrite en référence aux exemples suivants, donnés à titre illustratif et non limitatif.

### Exemples

Toutes les manipulations de matériaux sensibles à l'air sont faites en utilisant une rampe à vide technique standard (ou de type Schlenk) ou une boîte à gant sous argon.

Tous les produits proviennent de chez ALDRICH. L'oxyde de cadmium (pureté 0,999), l'oxyde de zinc (pureté 0,999), la poudre de sélénium (pureté 0,99999), le stéarate de zinc (pureté 0,95), le magnésium (pureté 0,9998), le 1-bromododécane (pureté 0,97), le 4-bromotoluène (pureté 0,98), le disulfure de carbone (pureté 0,999), le 1-dodécanethiol (pureté 0,985), le 4-méthoxythiophénol (pureté 0,97) ainsi que le toluène, le THF, le méthanol et le n-butanol anhydre sont utilisés tels quels ; la trioctylphosphine (TOP, pureté 0,9), le trioctylphosphine oxyde (TOPO, pureté 0,9) et l'hexadécylamine (HDA, pureté 0,9) sont purifiées par distillation.

Comme l'acide dodécylphosphonique (DDPA) n'est pas disponible commercialement, elle est synthétisée en suivant la méthode publiée dans Method. org. Chem. 12/1, pages 352-353, 435 (1963). Le produit est identifié par spectroscopie RMN des noyaux ¹H, ¹³C et ³¹P.

Caractérisation optique : les spectres d'absorption UV-visible sont mesurés sur un spectrophotomètre HEWLETT-PACKARD® 8 452A, les spectres de photoluminescence sont acquis par une caméra CCD couplée à un monochromateur JOBIN-YVON® HR 460 dont la résolution est 0,1 nm, la longueur d'onde d'excitation (365 nm) étant rejetée par un filtre passe-haut (coupure à 400 nm) .

Pour ces mesures spectroscopiques, les solutions colloïdales diluées de nanocristaux dans du toluène sont placées dans des cuvettes en quartz de chemin optique 1 mm.

Les spectres RMN sont réalisés dans les conditions suivantes : BRUKER® AC 200, 200 MHz.

### Exemple 1

Dans cet exemple, on décrit la préparation de nanocristaux coeur en CdSe recouverts par TOPO/TOP.

Ces cristaux serviront ultérieurement à la préparation de nanocristaux coeur/coquille CdSe/ZnSe.

51,4 mg de CdO (0,4 mmol) sont placés dans un ballon à deux cols sous flux constant d'argon purifié. Puis 1,15 mL de TOPO et 2,85 mL de HDA sont ajoutés, formant le mélange solvant avec une fraction molaire de 80 % de HDA. Le ballon est alors chauffé à 200°C, sous agitation magnétique. A ce point, 230 µL de DDPA (0,8 mmol) sont ajoutés et la température est augmentée jusqu'à environ 270°C pour une durée de 1 h. La réaction de complexation- à savoir la réaction de l'oxyde de cadmium avec la DDPA pour donner le phosphate de calcium - a lieu pendant cette durée et se manifeste par la formation d'une solution incolore. Par la suite, la température est redescendue à 250°C et stabilisée.

Une solution de sélénium de concentration 0,2 mol/L est préparée séparément, à température ambiante, en dissolvant 157,9 mg (2 mmol) de poudre de Se dans 10 mL de TOP. 2,5 mL de cette solution sont injectés rapidement dans le ballon contenant la solution de précurseur de Cd, toujours sous agitation vigoureuse. Des quantités de 100 µL sont périodiquement prélevées dans le milieu réactionnel, de façon à suivre le processus de croissance des nanocristaux. La distribution de taille la plus étroite est obtenue lorsque la réaction est arrêtée dans l'intervalle entre 3 et 30 mn après l'injection, le diamètre moyen des nanocristaux allant de 3,5 nm (pour 3 mn de réaction) à 4,6 nm (30 mn). Le milieu réactionnel est refroidi à environ 60°C lorsque la taille souhaitée est atteinte. Les nanocristaux coeur sont alors précipités par ajout d'un mélange de 10 mL de méthanol et de 1 mL de n-butanol. Ils sont ensuite séparés du liquide excédentaire par centrifugation, lavés au méthanol et séchés par un flux d'argon. Les nanocristaux peuvent être remis en solution dans divers solvants organiques comme le toluène, le chloroforme, les alcanes, éthers, etc., pour effectuer les mesures de leurs propriétés optiques.

Les spectres d'absorption et de photoluminescence de la série de prélèvements faits au cours de la réaction décrite ci-dessus permettant de tirer un certain nombre de conclusions.

Le spectre d'absorption présente, en plus du pic excitonique, des accidents caractéristiques d'états excités de plus haute énergie. Le pic de photoluminescence est de largeur à mi-hauteur faible, à savoir entre 25 à 29 nm, ce qui indique, sans conteste, que la distribution de taille des nanocristaux préparés très étroite. Ceci est confirmé par la détermination de la distribution de taille faite par MET : l'écart maximal par rapport à la moyenne est inférieur à 5 %, sans avoir recours à aucun procédé de tri en taille.

L'image en MET, obtenue avec une tension d'accélération de 300 kV sur un microscope électronique JEOL 3010, de nanocristaux de CdSe prélevés après 10 min. lors de la réaction ci-dessus montre que leur distribution de taille est suffisamment étroite, grâce au procédé selon l'invention, pour permettre leur « cristallisation » sur un super réseau tridimensionnel.

### Exemple 2

Dans cet exemple, on décrit la préparation de nanocristaux coeur/coquille en CdSe/ZnSe, recouverts par TOPO/TOP/HDA avec le stéarate de zinc comme source de zinc.

Dans un ballon, une solution de stéarate de zinc (ZnSt₂) de concentration 0,2 mol/L est préparée en mélangeant 632,3 mg de stéarate de zinc (ZnSt₂) (1 mmol) avec 5 mL de toluène et en chauffant modérément.

2,5 mL de cette dispersion qui reste trouble, sont mélangés à température ambiante avec le même volume d'une solution de Se dans la TOP de concentration 0,2 mol/L, préparée comme dans l'exemple 1. La totalité de ce mélange est placée dans une seringue.

Dans le ballon destiné à la synthèse, environ 20 mg de nanocristaux coeur de diamètre moyen 3,6 nm et avec une dispersion de taille inférieure à 5 % préparés comme décrit dans l'exemple 1, sont dispersés dans un mélange solvant consistant en 2,0 mL de TOPO et 2,0 mL de HDA (soit un rapport molaire d'environ 2 pour 3). Ce mélange est chauffé à 190°C. Dès que la température est stabilisée, la solution contenant le mélange ZnSt₂/Se est lentement injecté dans le ballon par un pousse-seringue, au rythme de 5 mL/h, le contenu du ballon étant vigoureusement agité. La croissance de la coquille est suivie par des prélèvements périodiques, comme décrit dans l'exemple 1. Lorsque l'injection du mélange Zn St₂/Se est terminée, le ballon est laissé à 190°C pendant 90 mn, afin de « recuire » les nanocristaux, pour éliminer les fautes d'empilement dans la coquille et à l'interface coeur/coquille. La synthèse se termine par le refroidissement du ballon à 60°C. Les nanocristaux obtenus sont précipités et purifiés par la méthode décrite dans l'exemple 1. Ils sont remis en solution dans un solvant organique pour la détermination de leurs propriétés optiques (cf. exemple 1).

### Exemple 3

Dans cet exemple, on décrit la synthèse de l'acide 1-dithiotridécanoïque.

Dans un ballon (tricol) sous atmosphère inerte, on place 5 équivalents de magnésium (0,1 mol/2,44 g) recouverts de 10 mL de THF anhydre. On y ajoute goutte par goutte 1 équivalent de bromododécane (0,02 mol/5,01 g), dissout dans 20 mL de THF anhydre. L'ajout fini, on porte le mélange à 60°C pendant 2 heures. On obtient une suspension grise.

Dans une boîte à gants, on prépare un ballon (bicol) avec 3 équivalents de disulfure de carbone (0,06 mol/4,56 g) dans 10 mL de THF et, à l'extérieur de la boîte, on refroidit ce mélange à -5°C. Sous atmosphère inerte, on y ajoute goutte à goutte la suspension grise préparée auparavant. Le mélange résultant devient jaune, puis orange. La température est ensuite remontée à l'ambiante, on laisse agiter pendant 12 h.

Le mélange réactionnel est hydrolysé avec 40 mL d'un mélange éther diéthylique/eau (1:1). La phase organique devient jaune-orange, la phase aqueuse est jaune. On acidifie avec 15 mL de HCl (0,2 M) : la phase aqueuse devient incolore car le produit sous forme d'acide va dans la phase organique. Afin d'optimiser le rendement, on extrait la phase aqueuse plusieurs fois à l'éther (pH ≤ 7). Les phases organiques sont réunies et extraites à l'eau (100 mL), séchées sur MgSO₄ et concentrées avec un évaporateur rotatif. On récupère 3,46 g(70%) d'une huile jaune vif, qui cristallise partiellement. Le produit est identifié par spectroscopie RMN des noyaux ¹H et ¹³C ainsi que par analyse élémentaire.

### Exemple 4

Dans cet exemple, on décrit la synthèse de l'acide 4-dithiotoluique.

Dans un ballon (tricol) sous atmosphère inerte, on place 5 équivalents de magnésium (0,05 mol/1,21 g) recouverts de 10 mL de THF anhydre. On y ajoute goutte par goutte 1 équivalent de 4-bromotoluène (0,01 mol/1,71 g), dissout dans 15 mL de THF anhydre. Après quelques gouttes, le reflux commence et la solution devient trouble. On porte ensuite le mélange à 60°C pendant 2 heures. La solution devient brun foncé.

Dans une boîte à gants, on prépare un ballon (bicol) avec 3 équivalents de disulfure de carbone (0,03 mol/2,34 g) dans 10 mL de THF et, à l'extérieur de la boîte, on refroidit ce mélange à -5°C. Sous atmosphère inerte, on y ajoute goutte par goutte la suspension brune préparée auparavant. Après quelques gouttes, la solution devient jaune, puis rouge foncé. On laisse remonter la température à l'ambiante et on laisse agiter pendant 12 h. Le mélange réactionnel est hydrolysé avec 40 mL d'un mélange éther diéthylique/eau (1:1). La phase organique devient jaune-orange. Afin de la purifier, la phase aqueuse est extraite à l'éther (150 mL) et les phases organiques réunies contenant des produits secondaires sont rejetées. Puis la phase aqueuse est acidifiée avec 25 mL de HCl (0,2 M) et extraite à l'éther : la phase organique est violet foncé. On poursuit l'acidification et l'extraction jusqu'à ce que la phase aqueuse soit incolore (25 mL 0,2 M HCl, 200 mL éther). Les phases organiques sont réunies et extraites à l'eau (100 mL). Après séchage sur MgSO₄, les phases organiques sont concentrées avec un évaporateur rotatif. On récupère 720 mg (43%) d'une huile violette, qui solidifie partiellement. Le produit est identifié par spectroscopie RMN des noyaux ¹H (voir Fig. 1B) et ¹³C ainsi que par analyse élémentaire.

### Exemple 5

Dans cet exemple, on décrit la préparation de nanocristaux selon l'invention enrobés par des ligands de type dithiolate.

Les nanocristaux de CdSe ou de CdSe/ZnSe, préparés comme décrit dans les exemples 1 et 2, sont redispersés dans du chloroforme anhydre avec une concentration d'environ 3 mg/mL. Pour l'échange des ligands, on ajoute 20 mg d'acide dithiocarboxylique, qui est soit l'acide 1-dithiotridécanoïque, soit l'acide 4-dithiotoluique, dans un microtube qui contient 1,5 mL de la solution des nanocristaux avec les "anciens" ligands. On laisse agiter pendant 2 heures à 30°C pour assurer un échange complet des anciens ligands par les nouveaux ligands selon l'invention. Les nanocristaux couverts par le dithiolate sont précipités ensuite avec 3 mL de méthanol et lavés plusieurs fois avec le même solvant afin d'enlever l'excès d'acide 1-dithiotridécanoïque ou 4-dithiotoluique, et de ligands désorbés de la surface. Les nanocristaux sont séchés à la rampe à vide et redispersés dans du chloroforme ou du CDCl₃. L'échange peut être caractérisé par les techniques standards d'analyse telles que RMN, UV-Vis ou IR.

### Exemple 6

Dans cet exemple, on décrit la préparation des nanocristaux enrobés par des ligands de type thiol.

La même méthode que celle utilisée pour la préparation des nanocristaux enrobés par des ligands de type dithiolate (voir exemple 5) peut être appliquée pour effectuer l'échange avec les ligands de type thiol qui sont le 4-méthoxythiophénol (Z-Y-SH avec Y = C₆H₄ et Z = OCH₃) et le dodécanethiol (Z-Y-SH avec Y=(CH₂)₁₂ et Z=H).

Cependant le temps de réaction doit être augmenté (jusqu'à au moins 72 h) afin d'obtenir un échange quasi-complet.

### Exemple 7

Dans cet exemple, on compare l'affinité pour la surface des nanocristaux des ligands dodécanethiol et tridécanodithiolate.

Afin d'étudier la stabilité des nanocristaux avec un ligand type thiol ou dithiolate vis-à-vis du ligand portant l'autre fonction d'ancrage, les nanocristaux préparés comme dans les exemples 5 et 6 sont redissouts dans du CHCl₃ et le ligand complémentaire est ajouté en excès.

Dans cet exemple, l'acide 4-dithiotoluique, préparé comme dans l'exemple 4, est utilisé car les protons aromatiques permettent une détection simple du taux d'échange dans des spectres ¹H-RMN (voir spectre RMN de l'acide 4-dithiotoluique sur la Fig. 1B), grâce au fort décalage de leur déplacement chimique par rapport aux protons des chaînes alkyles dans le TOPO, TOP et HDA.

Le thiol choisi pour la comparaison est le 4-méthoxythiophénol car il permet une bonne distinction de l'acide 4-dithiotoluique dans les spectres RMN à cause de la fonction méthoxy (voir spectre RMN du 4-méthoxythiophénol sur la Fig. 1A). La purification a été effectuée de la même manière qu'auparavant.

Les spectres ¹H-RMN montrent que le ligand de type thiol (à savoir le 4-méthoxythiophénol) est remplacé complètement au bout de 1 h par le ligand type dithiolate (à savoir l'acide dithiotoluique) (voir figures 1A à 1F). Dans le cas contraire, même après 72 h, environ 5-10% du ligand type dithiolate reste à la surface des nanocristaux. Ceci montre bien que la liaison formée pendant la réaction d'échange est plus stable dans le cas du ligand type dithiolate par rapport au thiol.

De manière détaillée, dans les figures 1A à 1F, la plus grande affinité des nouveaux ligands dithiolates pour la surface des nanocristaux par rapport à des ligands thiols de l'art antérieur est démontrée par spectroscopie RMN.

Comme on l'a décrit ci-dessus, dans un premier temps, les ligands à la surface des nanocristaux coeur/coquille CdSe/ZnSe sont remplacés par le 4-méthoxythiophénol (ligand de type thiol Z-Y-SH avec Y = C₆H₄ et Z = OCH₃ ; spectre de la Fig. 1C) (Exemple 6).

Un autre échantillon du même lot de nanocristaux est traité avec de l'acide 4-dithiotoluique (ligand type dithiolate Z-Y-C(S)SH avec Y = C₆H₄ et Z = CH₃ ; spectre de la Fig. 1D) (exemple 5). Malgré le temps de réaction beaucoup plus long pour l'échange avec le 4-méthoxythiophénol par rapport à l'acide 4-dithiotoluique (70 h au lieu de 1,5 h), le remplacement des ligands de départ (trioctylphosphine oxyde, trioctylphosphine, hexadécylamine) n'est pas total. Les pics importants dans le spectre RMN entre 0,8 ppm et 1,8 ppm, dus aux protons dans les chaînes alkyles de ces ligands, en sont la preuve. On observe également une disparition du pic de la fonction - SH(δ = 6,62 ppm) dans le spectre de la Fig. 1D, ce qui montre la déprotonation de l'acide 4-dithiotoluique au cours de la liaison avec la surface du nanocristal.

Pour la suite, comme on l'a déjà décrit, un excès de ligand complémentaire est ajouté à chacun des deux échantillons (voir exemple 7). Les thiols sont remplacés rapidement (au bout d'une heure) par les ligands type dithiolate, comme l'indique notamment l'absence du pic des protons du groupe méthoxy (δ = 3,7 ppm) dans le spectre RMN de la Fig. 1E. Dans le cas inverse, l'échange des ligands ne peut pas être détecté après 1 h et, même après un temps de réaction de 72 h, il reste des ligands type dithiolate à la surface des nanocristaux, visibles notamment grâce aux protons du groupe méthyl (δ = 2,3 ppm) dans le spectre RMN de la Fig. 1F.

### Exemple 8

Dans cet exemple, on réalise des expériences de photo-dégradation pour montrer la meilleure stabilité sous faisceaux lumineux des nanocristaux couverts par des ligands de type dithiolate (selon l'invention) par rapport aux nanocristaux recouverts par des thiols.

Pour ces expériences, les échantillons sont en solution dans du chloroforme et possèdent les mêmes densités optiques (0,1-0,5 au pic excitonique) et donc des concentrations identiques. Ils sont placés dans des cuvettes en quartz et irradiés en continu par une lampe à vapeur de mercure (longueurs d'onde d'irradiation 365 ou 254 nm). La désorption des ligands à la surface des nanocristaux diminue leur stabilité colloïdale et entraîne leur précipitation. Ceci est visible dans les spectres d'absorption UV-visible, qui sont enregistrés régulièrement. Plus le signal décroît vite, moins les nanocristaux sont stables. La photo-dégradation est également visible par un décalage du pic excitonique vers le bleu qui signifie une diminution de la taille moyenne des cristaux. Un thiol avec une longue chaîne alkyle, le 1-dodécanethiol, est choisi car c'est ce type de ligand qui résiste le mieux dans les expériences de photo-dégradation réalisées par Aldana et al. (J. Am. Chem. Soc. 123(36), p. 8844-8850 (2001)). Ce ligand est comparé à l'acide 1-dithiotridécanoïque, préparé selon l'exemple 3. Ainsi, la seule différence entre les deux ligands X-Y-Z est la fonction d'ancrage X (thiol ou dithiolate) tandis que les groupements chimiques Y-Z sont identiques (C₁₂H₂₅).

La figure 2A montre les spectres obtenus pour les échantillons de nanocristaux de CdSe avant l'échange de ligands à leur surface, dénommés par la suite cristaux de base. Après 33 h d'irradiation à 365 nm pratiquement tous les nanocristaux sont précipités et le pic excitonique à environ 570 nm n'est plus visible dans le spectre. Les ligands à la surface des nanocristaux de CdSe sont échangés par le 1-dodécanethiol, comme il est décrit dans l'exemple 6 ; on s'assure par spectroscopie RMN que l'échange est complet. Sous irradiation à 365 nm, le temps de photo-dégradation reste approximativement le même : au bout de 50 h tous les cristaux ont précipité (Fig. 2B).

Un deuxième échantillon du même lot de nanocristaux est traité avec l'acide 1-dithiotridécanoïque, comme décrit dans l'exemple 5 afin de recouvrir complètement la surface des cristaux par le ligand dithiolate. Dans ce cas, même après 67 h d'irradiation aucune précipitation des nanocristaux n'a lieu, comme le montre la présence du pic excitonique dans les spectres (Fig. 2C) et l'absence de dépôt sur les parois de la cuvette en quartz qui contient la solution colloïdale.

L'utilisation de lumière de plus grande énergie (254 nm) pour l'irradiation donne une échelle de temps plus courte pour la dégradation (1-2 h), cependant les nanocristaux couverts par les ligands type dithiolate s'avèrent de nouveau plus stable que les cristaux de base et les cristaux couverts par les thiols. Dans le cas de nanocristaux coeur/coquille CdSe/ZnSe, on observe le même ordre de stabilité que pour les cristaux de CdSe. Par ailleurs, la fluorescence de cristaux CdSe/ZnSe avant échange des ligands et après échange avec le thiol décroît rapidement en moins de 2 h d'irradiation à 365 nm, tandis que les cristaux CdSe/ZnSe couverts par les ligands type dithiolate fluorescent encore après 90 h sans changement de la longueur d'onde d'émission. Ceci est un grand avantage pour les applications qui sont basées sur les propriétés de photoluminescence des nanocristaux.

### Exemple 9

Dans cet exemple, on réalise un traitement photochimique d'un échantillon de nanocristaux fluorescents couverts par des ligands de type 1,1-dithiolate (selon l'invention), afin d'augmenter leur efficacité de fluorescence.

Pour cette expérience, une cuvette en quartz contenant une dispersion dans du chloroforme des nanocristaux coeur/coquille CdSe/ZnSe, traités avec de l'acide 1-dithiotridécanoique préparés de manière analogue à l'exemple 5, est placée à une distance de 4 cm d'une lampe à vapeur de mercure de 100 W.

On irradie l'échantillon en continu à une longueur d'onde de 365 nm.

La figure 3 montre l'évolution de l'intensité de la fluorescence en fonction du temps d'irradiation. Elle atteint son maximum qui correspond à environ 8 fois la valeur initiale, après environ 50 min. Une poursuite de l'exposition à la lumière UV pour une durée excédant environ 100 min entraîne à nouveau une diminution de la fluorescence.

Il est à noter que la longueur d'onde ainsi que la largeur de raie de fluorescence ne changent pas pendant l'irradiation.

## Revendications

1. Nanocristal comprenant un coeur inorganique constitué par au moins un métal et/ou au moins un composé semi-conducteur comprenant au moins un métal, la surface externe dudit nanocristal étant pourvue d'une couche de revêtement organique constituée par au moins un composé ligand de formule (I) .
X-Y-Z (I)
dans laquelle :
- X représente un groupe 1,1-dithiolate ou 1,1-disélénoate qui est lié par les deux atomes de soufre ou de sélénium à un atome de métal de la surface externe dudit nanocristal ;
- Y représente un groupe espaceur, tel qu'un groupe susceptible de permettre un transfert de charge ou un groupe isolant ;
- Z est un groupe choisi parmi les groupes susceptibles de communiquer des propriétés spécifiques au nanocristal.

2. Nanocristal selon la revendication 1 qui est constitué par au moins un métal.

3. Nanocristal selon la revendication 1 ou 2, dans lequel le métal est choisi parmi les métaux de transition, les métaux des terres rares, les métaux des groupes IIIA, IVA et VA du tableau périodique des éléments, et leurs alliages, et les mélanges de ces métaux et alliages.

4. Nanocristal selon la revendication 3, dans lequel le métal est choisi parmi l'aluminium, le cuivre, l'argent, l'or, l'indium, le fer, le platine, le nickel, le molybdène, le titane, le tungstène, l'antimoine, le palladium, le zinc, l'étain, leurs alliages, et les mélanges de ces métaux et alliages.

5. Nanocristal selon la revendication 3, dans lequel le nanocristal est constitué par de l'or.

6. Nanocristal selon la revendication 1 qui est constitué par au moins un composé semi-conducteur.

7. Nanocristal selon la revendication 1 ou la revendication 6, dans lequel le composé semi-conducteur est un semi-conducteur de formule AB dans lequel A représente un métal ou un métalloïde à l'état d'oxydation +II et B représente un élément à l'état d'oxydation -II.

8. Nanocristal selon la revendication 7, dans lequel A est choisi parmi Mg, Ca, Sr, Ba, Zn, Cd, Hg, Sn, Pb et les mélanges de ceux-ci, et B est choisi parmi O, S, Se, Te et les mélanges de ceux-ci.

9. Nanocristal selon la revendication 8, dans lequel le semi-conducteur de formule AB est choisi par MgS, MgSe, MgTe, CaS, CaSe, CaTe, SrS, SrSe, SrTe, BaS, BaSe, BaTe, ZnO, ZnS, ZnSe, ZnTe, CdS, CdSe, CdTe, HgS, HgSe, HgTe, SnS, SnSe, SnTe, PbS, PbSe, PbTe et les mélanges de ceux-ci.

10. Nanocristal selon la revendication 1 ou la revendication 6, dans lequel le composé semi-conducteur est un semi-conducteur de formule CD dans laquelle C représente un métal ou un métalloïde à l'état d'oxydation +III et D représente un élément à l'état d'oxydation -III.

11. Nanocristal selon la revendication 10, dans lequel C est choisi parmi Ga, In et leurs mélanges et D est choisi parmi Sb, As, P, N et leurs mélanges.

12. Nanocristal selon la revendication 11, dans lequel le semi-conducteur de formule CD est choisi parmi GaAs, GaSb, GaN, InGaAs, InN, InGaN, InP, InAs, InSb et leurs mélanges.

13. Nanocristal selon la revendication 1 ou la revendication 6, dans lequel le composé semi-conducteur est un semi-conducteur du groupe (IV) tel que le silicium ou le germanium.

14. Nanocristal selon l'une quelconque des revendications précédentes, qui a un diamètre de 15 à 150°Å.

15. Nanocristal selon l'une quelconque des revendications précédentes comprenant en outre une ou plusieurs coquilles entourant ledit coeur, lesdites coquilles étant constituées d'une couche d'un métal et/ou d'au moins un composé semi-conducteur comprenant au moins un métal.

16. Nanocristal selon la revendication 15, dans lequel le coeur a un diamètre de 15 à 150 Å et la(les) coquille(s) a(ont) une épaisseur de 3 à 30 Å.

17. Nanocristal selon l'une quelconque des revendications précédentes, dans lequel la couche de revêtement organique a une épaisseur de 5 à 100 Å.

18. Nanocristal selon la revendication 15, dans lequel le coeur est en un premier composé semi-conducteur ; et la seule coquille entourant ledit coeur lorsqu'il y a une seule coquille, ou la première coquille entourant ledit coeur lorsque il y a plusieurs coquilles, est en un second composé semi-conducteur différent du premier composé semi-conducteur.

19. Nanocristal selon la revendication 18, dans lequel le premier composé semi-conducteur est un composé semi-conducteur de type A(II)B(VI) tel que CdSe, et le second composé est un composé semi-conducteur de type A(II)B(VI) différent du premier composé tel que ZnSe, ZnS ou CdS.

20. Nanocristal selon l'une quelconque des revendications 15 à 19 comprenant plusieurs coquilles, deux coquilles successives étant en des composés semi-conducteurs différents ; par exemple choisis parmi ZnSe, CdS, ZnS.

21. Nanocristal selon la revendication 20, comprenant une première coquille en ZnSe ou en CdS et une seconde coquille en ZnS.

22. Nanocristal selon l'une quelconque des revendications précédentes dans lequel Y répond à la formule suivante :
-R₁-R- (II)
où
R₁ représente :
• une liaison simple ;
• un groupe 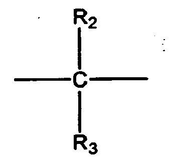 où R₂ et R₃ représentent indépendamment un hydrogène, un radical alkyle, un radical aryle, un radical alcoxy, un halogène ;
• un groupe 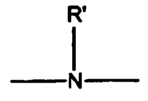 où R' représente un hydrogène, un radical alkyle, un radical aryle, un radical alcoxy, un halogène ;
• un groupe 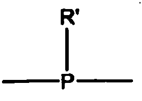 où R' a la signification déjà donnée plus haut ;
• un groupe 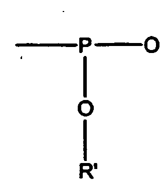 où R' a la signification déjà donnée plus haut ;
• -O- ;
• -S- ;
• -Se- ;
et R représente un groupe alkylène linéaire ou ramifié ayant de 1 à 30 atomes de carbone, de préférence de 1 à 8 ; un ou plusieurs atomes de carbone dudit groupe alkylène étant éventuellement remplacés par un ou plusieurs hétéroatomes choisis parmi O, N, S; P et Si ; ledit groupe alkylène comprenant en outre éventuellement une ou plusieurs doubles et/ou triples liaisons telles que des doubles et/ou triples liaisons carbone-carbone ; et ledit groupe alkylène étant en outre éventuellement substitué par un ou plusieurs groupes choisis parmi les halogènes, tels que le chlore, le brome, l'iode et le fluor, les hétérocycles, les radicaux aryle, hydroxyle, alcoxy, amino, acyle, carboxamido ; =O ; -CHO ; -CO₂H, -SO₃H, -PO₃H₂, -PO₄H₂, -NHSO₃H, sulfonamide ; monoalkylamino, trialkylammonium, ou bien encore par un radical dialkylamino, dans lequel les deux groupements alkyle peuvent former, conjointement avec l'atome d'azote dudit groupement dialkyl(C₁-C₄)amino, auquel ils sont liés, un cycle pouvant être interrompu par un ou plusieurs atomes d'azote, d'oxygène ou de soufre, et les groupes Z ; ou R représente un hétérocycle, un radical aryle, un radical aryle condensé sur un ou plusieurs autres cycles aryles et/ou cycles alkyles et/ou hétérocycles, un radical cycloalkyle, un radical cycloalkyl-alkyle, un radical alkyl-cycloalkyle, un radical arylalkyle, un radical alkylaryle, un radical hétérocycloalkyle, un radical alkyl-hétérocycloalkyle.

23. Nanocristal selon la revendication 22, dans lequel Y représente une chaîne alkylène -(CH₂)ₙ- avec n = 1 à 18, de préférence n = 12, ou un cycle aromatique éventuellement substitué tel que 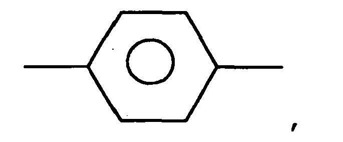 ou une chaîne alcoxy -[(CH₂)ₘO(CH₂)ₘ]ₙ- avec m=1 à 4 et n=1 à 6.

24. Nanocristal selon l'une quelconque des revendications précédentes, dans lequel le groupe Z est choisi pour obtenir une solubilité du nanocristal dans un solvant spécifique défini par une polarité donnée.

25. Nanocristal selon la revendication 24, dans lequel le groupe Z est choisi parmi les groupes qui permettent la solubilisation du nanocristal dans les solvants apolaires, et/ou les solvants à faible polarité tels que les hydrocarbures.

26. Nanocristal selon la revendication 24, dans lequel le groupe Z est choisi parmi les groupes qui permettent la solubilisation du nanocristal dans les solvants polaires tels que l'eau, les alcools et leurs mélanges.

27. Nanocristal selon l'une quelconque des revendications précédentes, dans lequel le groupe Z est choisi parmi les groupes qui permettent la liaison du nanocristal avec d'autres molécules telles que les molécules biologiques et les polymères et oligomères conjugués.

28. Nanocristal selon l'une quelconque des revendications précédentes, dans lequel le groupe Z contient des polymères ou oligomères conjugués ou des molécules biologiques.

29. Nanocristal selon l'une quelconque des revendications précédentes, dans lequel le groupe Z est choisi parmi les groupes qui permettent la liaison du nanocristal avec un ou plusieurs autres nanocristaux.

30. Nanocristal selon l'une quelconque des revendications précédentes, dans lequel le groupe Z est choisi parmi les groupes hydrophiles, en particulier les groupes polaires, tels que les groupes hydroxyles, les groupes formyles, les alcoxydes, les acides carboxyliques, les amines, les polyéthers, tels que le polyéthylèneglycol, et les groupes chargés tels que les groupes carboxylates, les sulfonates, les phosphates, les nitrates, les sels d'ammonium et analogues.

31. Nanocristal selon l'une quelconque des revendications précédentes, dans lequel le groupe Z est identique au groupe X.

32. Nanocristal selon l'une quelconque des revendications précédentes, dans lequel plusieurs groupes Z identiques ou différents sont présents sur le même ligand.

33. Nanocristal selon l'une quelconque des revendications précédentes, dans lequel plusieurs groupes X sont présents sur le même ligand.

34. Nanocristal selon l'une quelconque des revendications précédentes, dans lequel plusieurs ligands qui différent par le ou les groupes Y et/ou Z qu'ils contiennent se trouvent sur le même nanocristal.

35. Nanocristal selon l'une quelconque des revendications précédentes, dans lequel ledit nanocristal est un nanocristal fluorescent, photoluminescent.

36. Nanocristal selon la revendication 35, dans lequel ledit nanocristal fluorescent, photoluminescent a été soumis à une irradiation par une lumière.

37. Nanocristal selon la revendication 36, dans lequel ladite lumière est une lumière ultraviolette.

38. Procédé de préparation d'un nanocristal selon l'une quelconque des revendications 1 à 37, dans lequel on effectue les étapes successives suivantes :
a) on prépare une solution dans un solvant, de nanocristaux ayant un coeur inorganique constitué par au moins un métal et/ou au moins un composé semi-conducteur comprenant au moins un métal et éventuellement une ou plusieurs coquille(s) entourant ledit coeur, ladite (lesdites) coquille(s) étant constituée(s) d'une couche d'un métal et/ou d'au moins un composé semi-conducteur comprenant au moins un métal, la surface externe dudit nanocristal étant pourvue d'une couche de revêtement organique constituée par au moins un premier composé ligand différent du composé ligand de formule (I) ;
b) on ajoute à la solution de l'étape a) des composés ligands de formule (I), solubles dans le solvant de ladite solution de l'étape a), de façon à ce que les composés ligands de formule (I) soient en excès par rapport aux premiers composés ligands différents du composé ligand de formule (I) dont sont pourvus les nanocristaux ;
c) on laisse en contact les composés ligands de formule (I) et les nanocristaux, de préférence sous agitation, pendant une durée suffisante pour réaliser à la surface des nanocristaux un échange essentiellement total des premiers composés ligands par les composés ligands de formule (I).

39. Procédé selon la revendication 38, dans lequel dans l'étape b), les composés ligands de formule (I) sont ajoutés à la solution de l'étape a) sous forme d'acide HS (S) C-Y-Z ou HSe(Se)C-Y-Z, ou sous forme de sel M⁽⁺⁾ S (S) C-Y-Z ⁽⁻⁾ ou M⁽⁺⁾ Se (Se) C-Y-Z ⁽⁻⁾ avec M⁽⁺⁾ = Li⁽⁺⁾, Na⁽⁺⁾, K⁽⁺⁾, Rb⁽⁺⁾, Cs⁽⁺⁾, NH₄⁽⁺⁾, PH₄⁽⁺⁾.

40. Procédé selon la revendication 38 dans lequel dans l'étape b) le rapport molaire des composés ligands de formule (I) ajoutés aux premiers composés ligands est de 5 :1 à 15 :1.

41. Procédé selon la revendication 38, dans lequel la durée de la mise en contact de l'étape c) est de 1 à 5 heures.

42. Procédé selon l'une quelconque des revendications 38 à 41 dans lequel le solvant est choisi parmi le chloroforme, le dichlorométhane, le toluène, l'heptane, un autre solvant apolaire ou à faible polarité ou un mélange de ceux-ci.

43. Procédé de préparation d'un nanocristal selon l'une quelconque des revendications 1 à 37, dans lequel on effectue les étapes successives suivantes :
a) on prépare une solution dans un premier solvant, de nanocristaux ayant un coeur inorganique constitué par au moins un métal et/ou au moins un composé semi-conducteur comprenant au moins un métal et éventuellement une ou plusieurs coquille(s) entourant ledit coeur, ladite (lesdites) coquille (s) étant constituée(s) d'une couche d'un métal et/ou d'au moins un composé semi-conducteur comprenant au moins un métal, la surface externe dudit nanocristal étant pourvue d'une couche de revêtement organique constituée par au moins un premier composé ligand différent du composé ligand de formule (I)
b) on ajoute à la solution de l'étape a) une solution des composés ligands de formule (I) dans un second solvant, lesdits composés ligands de formule (I) n'étant pas solubles dans ledit premier solvant, moyennant quoi on obtient un mélange biphasique comprenant une première phase constituée par la solution des nanocristaux dans le premier solvant et une seconde phase constituée par la solution des composés ligands de formule (I) dans le second solvant ;
c) on laisse en contact lesdites première et seconde phases, de préférence sous agitation, pendant une durée suffisante pour que les nanocristaux soient essentiellement complètement transférés dans ladite seconde phase et que soit réalisé à la surface des nanocristaux un échange essentiellement total des premiers composés ligands par les composés ligands de formule (I).

44. Procédé selon la revendication 43, dans lequel dans l'étape b), les composés ligands de formule (I) sont ajoutés à la solution de l'étape a) sous forme d'acide HS(S)C-Y-Z ou HSe(Se)C-Y-Z, ou sous forme de sel M⁽⁺⁾ S (S) C-Y-Z ⁽⁻⁾ ou M⁽⁺⁾ Se (Se) C-Y-Z ⁽⁻⁾ avec M⁽⁺⁾ = Li ⁽⁺⁾, Na ⁽⁺⁾, K⁽⁺⁾, Rb⁽⁺⁾, Cs⁽⁺⁾, NH₄⁽⁺⁾, PH₄⁽⁺⁾.

45. Procédé selon la revendication 44, dans lequel la durée de mise en contact de l'étape c) est de 1 à 5 heures.

46. Procédé selon l'une quelconque des revendications 43 à 45, dans lequel le premier solvant est choisi parmi les solvants apolaires et les solvants de faible polarité tels que le chloroforme, le dichlorométhane, le toluène, l'heptane, l'hexane et leurs mélanges.

47. Procédé selon l'une quelconque des revendications 43 à 46, dans lequel le second solvant est choisi parmi les solvants polaires tels que les alcools, tel que le méthanol et l'éthanol, l'eau et leurs mélanges.

48. Procédé selon l'une quelconque des revendications 38 à 47, dans lequel le premier composé ligand différent du composé ligand de formule (I) est choisi parmi les phosphines oxydes tels que les trialkylphosphine oxyde dont le groupe alkyle comprend de 4 à 12 atomes de carbone tel que le trioctylphosphine oxyde (TOPO) ; les séléniures de phosphines tels que les séléniures de trialkylphosphines dont le groupe alkyle comprend de 4 à 12 atomes de carbone, tel que le séléniure de trioctylphosphine (TOPSe) ; les trialkylphosphines tels que les trialkylphosphines dont le groupe alkyle comprend de 4 à 12 atomes de carbone tel que la trioctylphosphine (TOP) ; les amines primaires telles que les alkylamines dont le groupe alkyle comprend de 6 à 24 atomes de carbone telle que l'hexadécylamine (HDA) ; les thiols tels que le dodécanethiol ; et les acides carboxyliques, tels que l'acide stéarique ou l'acide oléique ; et les mélanges de ceux-ci.

49. Procédé selon l'une quelconque des revendications 38 à 48, dans lequel à l'issue de l'étape c), les nanocristaux pourvus d'une couche de revêtement organique constitué par les ligands (I) sont précipités, séparés, lavés puis séchés.

50. Procédé selon l'une quelconque des revendications 38 à 49, dans lequel les nanocristaux pourvus d'une couche de revêtement organique constitué par les ligands (I) sont des nanocristaux fluorescents, photoluminescents.

51. Procédé selon la revendication 50, dans lequel, à l'issue de l'étape c), les nanocristaux pourvus d'une couche de revêtement organique constitué par les ligands (I), éventuellement précipités, séparés, lavés puis séchés sont soumis à une irradiation par une lumière.

52. Procédé selon la revendication 51, dans lequel ladite lumière est une lumière ultraviolette, par exemple d'une longueur d'onde de 365 nm.

53. Procédé selon l'une quelconque des revendications 51 à 52, dans lequel l'irradiation a une durée de une minute à 10 heures, de préférence de 10 minutes à 200 minutes, de préférence encore de 50 à 100 minutes, par exemple 60 minutes.

54. Procédé selon l'une quelconque des revendications 51 à 53, dans lequel l'irradiation est réalisée en dispersant les nanocristaux pourvus d'une couche de revêtement organique constitué par les ligands (I) dans un solvant et exposant les nanocristaux à une irradiation par une lumière.

55. Procédé selon la revendication 54, dans lequel ledit solvant est choisi parmi les solvants apolaires et les solvants de faible polarité tels que le chloroforme, le dichlorométhane, le toluène, l'heptane, l'hexane et leurs mélanges ou parmi les solvants polaires tels que les alcools, l'eau, et leurs mélanges.

## Claims

1. Nanocrystal comprising an inorganic core consisting of at least one metal and/or at least one semiconductor compound comprising at least one metal, the outer surface of said nanocrystal being provided with at least one organic coating layer consisting of at least one ligand compound according to formula (I):
X-Y-Z (I)
wherein:
- X represents a 1,1-dithiolate or 1,1-diselenoate group which is bound by both sulphur or selenium atoms to a metal atom of the outer surface of said nanocrystal;
- Y represents a spacer group, such as a group capable of enabling a charge transfer or an insulating group;
- Z is a group selected from the groups capable of communicating specific properties to the nanocrystal.

2. Nanocrystal according to claim 1 which consists of at least one metal.

3. Nanocrystal according to claim 1 or 2, wherein the metal is selected from the transition metals, the rare earth metals, the group IIIA, IVA and VA metals from the periodic table of the elements, and alloys thereof, and mixtures of said metals and alloys.

4. Nanocrystal according to claim 3, wherein the metal is selected from aluminium, copper, silver, gold, indium, iron, platinum, nickel, molybdenum, titanium, tungsten, antimony, palladium, zinc, tin, alloys thereof, and mixtures of said metals and alloys.

5. Nanocrystal according to claim 3, wherein the nanocrystal consists of gold.

6. Nanocrystal according to claim 1 which consists of at least one semiconductor compound.

7. Nanocrystal according to claim 1 or claim 6, wherein the semiconductor compound is a semiconductor according to formula AB wherein A represents a metal or a metalloid in the + II oxidation state and B represents an element in the -II oxidation state.

8. Nanocrystal according to claim 7, wherein A is selected from Mg, Ca, Sr, Ba, Zn, Cd, Hg, Sn, Pb and mixtures thereof, and B is selected from 0, S, Se, Te and mixtures thereof.

9. Nanocrystal according to claim 8, wherein the semiconductor according to formula AB is selected from MgS, MgSe, MgTe, CaS, CaSe, CaTe, SrS, SrSe, SrTe, BaS, BaSe, BaTe, ZnO, ZnS, ZnSe, ZnTe, CdS, CdSe, CdTe, HgS, HgSe, HgTe, SnS, SnSe, SnTe, PbS, PbSe, PbTe and mixtures thereof.

10. Nanocrystal according to claim 1 or claim 6, wherein the semiconductor compound is a semiconductor according to formula CD wherein C represents a metal or a metalloid in the + III oxidation state and D represents an element in the -III oxidation state.

11. Nanocrystal according to claim 10, wherein C is selected from Ga, In and mixtures thereof and D is selected from Sb, As, P, N and mixtures thereof.

12. Nanocrystal according to claim 11, wherein the semiconductor according to formula CD is selected from GaAs, GaSb, GaN, InGaAs, InN, InGaN, InP, InAs, InSb and mixtures thereof.

13. Nanocrystal according to claim 1 or claim 6, wherein the semiconductor compound is a group (IV) semiconductor such as silicon or germanium.

14. Nanocrystal according to any of the preceding claims, which has a diameter of 15 to 150°Å.

15. Nanocrystal according to any of the preceding claims also comprising one or more shells surrounding said core, said shells consisting of a layer of a metal and/or of at least one semiconductor compound comprising at least one metal.

16. Nanocrystal according to claim 15, wherein the core has a diameter of 15 to 150 Å and the shell (s) has/have a thickness of 3 to 30 Å.

17. Nanocrystal according any of the preceding claims, wherein the organic coating layer has a thickness of 5 to 100 Å.

18. Nanocrystal according to claim 15, wherein the core consists of a first semiconductor compound; and the single shell surrounding said core in the case of a single shell, or the first shell surrounding said core in the case of several shells, consists of a second semiconductor compound, different to the first semiconductor compound.

19. Nanocrystal according to claim 18, wherein the first semiconductor compound is an A(II)B(VI) type semiconductor compound such as CdSe, and the second compound is a A(II)B(VI) type semiconductor compound different to the first compound such as ZnSe, ZnS or CdS.

20. Nanocrystal according to any of claims 15 to 19 comprising several shells, two successive shells consisting of different semiconductor compounds; for example selected from ZnSe, CdS, ZnS.

21. Nanocrystal according to claim 20, comprising a first shell made of ZnSe or CdS and a second shell made of ZnS.

22. Nanocrystal according to any of the preceding claims wherein Y complies with the following formula:
-R₁-R- (II)
where
R₁ represents:
- a single bond;
- a group 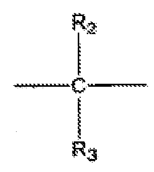 where R₂ and R₃ represent independently a hydrogen, an alkyl radical, an aryl radical, an alcoxy radical, a halogen;
- a 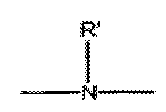 group where R' represents a hydrogen, an alkyl radical, an aryl radical, an alcoxy radical, a halogen;
- a 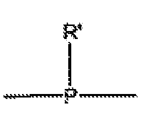 group where the meaning of R' is that already given above;
- a 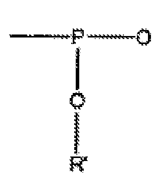 group where the meaning of R' is that already given above;
- -O-;
- -S-;
- -Se-;
and R represents a linear or branched alkylene group having 1 to 30 carbon atoms, preferentially 1 to 8; one or more carbon atoms from said alkylene group being possibly replaced by one or more heteroatoms selected from 0, N, S, P and Si; said alkylene group also possibly comprising one or more double and/or triple bonds such as double and/or triple carbon-carbon bonds; and said alkylene group being also possibly substituted by one or more groups selected from the halogens, such as chlorine, bromine, iodine and fluorine, heterocycles, the aryl, hydroxyl, alcoxy, amino, acyl, carboxamide radicals; = 0; -CHO; -CO₂H, -SO₃H, -PO₃H₂, -PO₄H₂, -NHSO₃H, sulphonamide; monoalkylamino, trialkylammonium radicals or by a dialkylamino radical, wherein both alkyl groups may form, in conjunction with the nitrogen atom of said dialkyl (C₁-C₄) amino group, with which they are bound, a cycle possibly being interrupted by one or several nitrogen, oxygen or sulphur atoms, and Z groups; where R represents a heterocycle, an aryl radical, an aryl radical condensed on one or several other aryl cycles and/or alkyl cycles and/or heterocycles, a cycloalkyl radical, a cycloalkyl-alkyl radical, an alkylcycloalkyl radical, an aryl alkyl radical, an alkyl aryl radical, a heterocycle alkyl radical, an alkyl-heterocycle alkyl radical.

23. Nanocrystal according to claim 22, wherein Y represents an alkylene chain -(CH₂)ₙ- where n = 1 to 18, preferentially n = 12, or a possibly substituted aromatic cycle such as 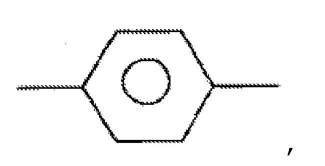 or an alcoxy chain -[(CH₂)ₘO(CH₂)ₘ]ₙ- where m = 1 to 4 and n = 1 to 6.

24. Nanocrystal according to any of the preceding claims, wherein group Z is selected to obtain a solubility of the nanocrystal in a specific solvent defined by a given polarity.

25. Nanocrystal according to claim 24, wherein group Z is selected from the groups enabling solubilisation of the nanocrystal in non-polar solvents, and/or low-polarity solvents such as hydrocarbons.

26. Nanocrystal according to claim 24, wherein group Z is selected from the groups enabling solubilisation of the nanocrystal in polar solvents such as water, alcohols and mixtures thereof.

27. Nanocrystal according to any of the preceding claims, wherein group Z is selected from the groups enabling bonding of the nanocrystal with other molecules such as biological molecules and polymers and conjugate oligomers.

28. Nanocrystal according to any of the preceding claims, wherein group Z contains polymers or conjugate oligomers or biological molecules.

29. Nanocrystal according to any of the preceding claims, wherein group Z is selected from groups enabling bonding of the nanocrystal with one or more other nanocrystals.

30. Nanocrystal according to any of the preceding claims, wherein group Z is selected from the hydrophilic groups, particularly the polar groups, such as hydroxyl groups, formyl groups, alcoxides, carboxylic acids, amines, polyethers, such as polyethylene glycol, and charged groups such as the carboxylate groups, sulphonates, phosphates, nitrates, ammonium salts and the like.

31. Nanocrystal according to any of the preceding claims, wherein group Z is identical to group X.

32. Nanocrystal according to any of the preceding claims, wherein several identical or different Z groups are present on the same ligand.

33. Nanocrystal according to any of the preceding claims, wherein several X groups are present on the same ligand.

34. Nanocrystal according to any of the preceding claims, wherein several ligands differing due to the Y and/or Z groups contained therein are located on the same nanocrystal.

35. Nanocrystal according to any of the preceding claims, wherein said nanocrystal is a fluorescent, photoluminescent nanocrystal.

36. Nanocrystal according to claim 35, wherein said fluorescent, photoluminescent nanocrystal has been subjected to light irradiation.

37. Nanocrystal according to claim 36, wherein said light is an ultraviolet light.

38. Method to prepare a nanocrystal according any of claims 1 to 37, wherein the following successive steps are performed:
a) a solution is prepared in a solvent, of nanocrystals having an inorganic core consisting of at least one metal and/or at least one semiconductor compound comprising at least one metal and possibly one or more shell(s) surrounding said core, said shell(s) consisting of a layer of a metal and/or of at least one semiconductor compound comprising at least one metal, the outer surface of said nanocrystal being provided with an organic coating layer consisting of at least one first ligand compound different to the ligand compound according to formula (I);
b) to the solution according to step a), ligand compounds according to formula (I) are added, which are soluble in the solvent of said solution according to step a), so that the ligand compounds according to formula (I) are in excess with respect to the first ligand compounds different to the ligand compound according to formula (I) provided in the nanocrystals;
c) the ligand compounds according to formula (I) and the nanocrystals are placed in contact, preferentially under stirring, for a sufficient time to produce on the surface of the nanocrystals an essentially total replacement of the first ligand compounds by the ligand compounds according to formula (I).

39. Method according to claim 38, wherein in step b), the ligand compounds according to formula (I) are added to the solution according to step a) in the form of acid HS (S) C-Y-2 or HSe (Se) C-Y-2, or in the form of salt M⁽⁺⁾S(S)C-Y-Z⁽⁻⁾ or M⁽⁺⁾Se(Se)C-Y-Z⁽⁻⁾ where M⁽⁺⁾ = Li⁽⁺⁾, Na⁽⁺⁾, K⁽⁺⁾, Rb⁽⁺⁾, Cs⁽⁺⁾, NH4⁽⁺⁾, PH₄⁽⁺⁾.

40. Method according to claim 38 wherein in step b) the molar ratio of the ligand compounds according to formula (I) added to the first ligand compounds is 5:1 to 15:1.

41. Method according to claim 38, wherein the contact time according to step c) is 1 to 5 hours.

42. Method according to any of claims 38 to 41 wherein the solvent is selected from chloroform, dichloromethane, toluene, heptane, another non-polar or low-polarity solvent or a mixture thereof.

43. Method to prepare a nanocrystal according to any of claims 1 to 37, wherein the following successive steps are performed:
a) a solution is prepared in a first solvent, of nanocrystals having an inorganic core consisting of at least one metal and/or at least one semiconductor compound comprising at least one metal and possibly one or more shell(s) surrounding said core, said shell(s) consisting of a layer of a metal and/or of at least one semiconductor compound comprising at least one metal, the outer surface of said nanocrystal being provided with an organic coating layer consisting of at least one first ligand compound different to the ligand compound according to formula (I);
b) to the solution according to step a), ligand compounds according to formula (I) in a second solvent are added, said ligand compounds according to formula (I) not being soluble in said first solvent, whereby a two-phase mixture comprising a first phase consisting of the nanocrystal solution in the first solvent and a second phase consisting of the solution of the ligand compounds according to formula (I) in the second solvent is obtained;
c) said first and second phases are placed in contact, preferentially under stirring, for a sufficient time so that the nanocrystals are essentially completely transferred to said second phase and that an essentially total replacement of the first ligand compounds by the ligand compounds according to formula (I) is produced on the surface of the nanocrystals.

44. Method according to claim 43, wherein in step b), the ligand compounds according to formula (I) are added to the solution according to step a) in the form of acid HS (S) C-Y-2 or HSe (Se) C-Y-2, or in the form of salt M⁽⁺⁾S(S)C-Y-Z⁽⁻⁾ or M⁽⁺⁾Se(Se)C-Y-Z⁽⁻⁾ where M⁽⁺⁾ = Li⁽⁺⁾, Na⁽⁺⁾, K⁽⁺⁾, Rb⁽⁺⁾, Cs⁽⁺⁾, NH₄⁽⁺⁾, PH₄⁽⁺⁾.

45. Method according to claim 44, wherein the contact time according to step c) is 1 to 5 hours.

46. Method according to any of claims 43 to 45 wherein the first solvent is selected from non-polar and low-polarity solvents such as chloroform, dichloromethane, toluene, heptane, hexane and mixtures thereof.

47. Method according to any of claims 43 to 46, wherein the second solvent is selected from polar solvents such as alcohols, such as methanol and ethanol, water and mixtures thereof.

48. Method according to any of claims 38 to 47, wherein the first ligand compound different to the ligand compound according to formula (I) is selected from phosphine oxides such as trialkylphosphine oxide wherein the alkyl group comprises 4 to 12 carbon atoms such as trioctylphosphine oxide (TOPO); phosphine selenides such as trialkylphosphine selenides wherein the alkyl group comprises 4 to 12 carbon atoms, such as trioctylphosphine selenide (TOPSe); trialkylphosphines such as trialkylphosphines wherein the alkyl group comprises 4 to 12 carbon atoms such trioctylphosphine (TOP); primary amines such as alkylamines wherein the alkyl group comprises 6 to 24 carbon atoms such as hexadecylamine (HDA); thiols such as dodecanethiol; and carboxylic acids, such as stearic acid or oleic acid; and mixtures thereof.

49. Method according to any of claims 38 to 48, wherein, following step c), the nanocrystals provided with an organic coating layer consisting of the ligands (I) are precipitated, separated, washed and dried.

50. Method according to any of claims 38 to 49,
wherein the nanocrystals provided with an organic coating layer consisting of ligands (I) are fluorescent, photoluminescent nanocrystals.

51. Method according to claim 50, wherein, following step c), the nanocrystals provided with an organic coating layer consisting of ligands (I), possibly precipitated, separated, washed and dried are subjected to light irradiation.

52. Method according to claim 51, wherein said light is an ultraviolet light, for example with a 365 nm wavelength.

53. Method according to any of claims 51 to 52, wherein the duration of the irradiation is from one minute to 10 hours, preferentially from 10 minutes to 200 minutes, more preferentially from 50 to 100 minutes, for example 60 minutes.

54. Method according to any of claims 51 to 53, wherein the irradiation is performed by dispersing the nanocrystals provided with an organic coating layer consisting of ligands (I) in a solvent and exposing the nanocrystals to light irradiation.

55. Method according to claim 54, wherein said solvent is selected from non-polar solvents or low-polarity solvents such as chloroform, dichloromethane, toluene, heptane, hexane and mixtures thereof or from polar solvents such as alcohols, water, and mixtures thereof.

## Patentansprüche

1. Nanokristall umfassend einen anorganischen Kern, der aus wenigstens einem Metall und/oder wenigstens einer wenigstens ein Metall umfassenden Halbleiterverbindung besteht, wobei die äußere Oberfläche des Nanokristalls mit einer organischen Überzugsschicht versehen ist, die sich aus wenigstens einer Ligandenverbindung der Formel (I) zusammensetzt:
X-Y-Z (I)
worin
- X eine 1,1-Dithiolat- oder 1,1-Diselenoatgruppe darstellt, die durch die beiden Schwefel- oder Selenatome an ein Metallatom der äußeren Oberfläche des Nanokristalls gebunden ist,
- Y eine Abstandsgruppe wie etwa eine Gruppe, die eine Ladungsübertragung ermöglichen kann oder eine isolierenden Gruppe darstellt,
- Z eine Gruppe ist, die aus den Gruppen ausgewählt ist, die dem Nanokristall spezielle Eigenschaften vermitteln können.

2. Nanokristall gemäß Anspruch 1, der sich aus wenigstens einem Metall zusammensetzt.

3. Nanokristall gemäß Anspruch 1 oder 2, bei dem das Metall aus den Übergangsmetallen, Seltenerdmetallen, Metallen der Gruppen IIIA, IVA und VA des Periodensystems der Elemente und ihren Legierungen und den Gemischen dieser Metalle und Legierungen ausgewählt ist.

4. Nanokristall gemäß Anspruch 3, bei dem das Metall aus Aluminium, Kupfer, Silber, Gold, Indium, Eisen, Platin, Nickel, Molybdän, Titan, Wolfram, Antimon, Palladium, Zink, Zinn, ihren Legierungen und den Gemischen dieser Metalle und Legierungen ausgewählt ist.

5. Nanokristall gemäß Anspruch 3, wobei sich der Nanokristall aus Gold zusammensetzt.

6. Nanokristall gemäß Anspruch 1, der sich aus mindestens einer Halbleiterverbindung zusammensetzt.

7. Nanokristall gemäß Anspruch 1 oder Anspruch 6, bei dem die Halbleiterverbindung ein Halbleiter der Formel AB ist, worin A ein Metall oder Nichtmetall im Oxidationszustand +II darstellt und B ein Element im Oxidationszustand -II darstellt.

8. Nanokristall gemäß Anspruch 7, bei dem A aus Mg, Ca, Sr, Ba, Zn, Cd, Hg, Sn, Pb und deren Gemischen ausgewählt ist und B aus O, S, Se, Te und deren Gemischen ausgewählt ist.

9. Nanokristall gemäß Anspruch 8, bei dem der Halbleiter der Formel AB aus MgS, MgSe, MgTe, CaS, CaSe, CaTe, SrS, SrSe, SrTe, BaS, BaSe, BaTe, ZnO, ZnS, ZnSe, ZnTe, CdS, CdSe, CdTe, HgS, HgSe, HgTe, SnS, SnSe, SnTe, PbS, PbSe, PbTe und deren Gemischen ausgewählt ist.

10. Nanokristall gemäß Anspruch 1 oder Anspruch 6, bei dem die Halbleiterverbindung ein Halbleiter der Formel CD ist, worin C ein Metall oder Nichtmetall im Oxidationszustand +III darstellt und D ein Element im Oxidationszustand -III darstellt.

11. Nanokristall gemäß Anspruch 10, bei dem C aus Ga, In und ihren Gemischen ausgewählt ist und D aus Sb, As, P, N und ihren Gemischen ausgewählt ist.

12. Nanokristall gemäß Anspruch 11, bei dem der Halbleiter der Formel CD aus GaAs, GaSb, GaN, InGaAs, InN, InGaN, InP, InAs, InSb und ihren Gemischen ausgewählt ist.

13. Nanokristall gemäß Anspruch 1 oder Anspruch 6, bei dem die Halbleiterverbindung ein Halbleiter der Gruppe (IV) wie etwa Silizium oder Germanium ist.

14. Nanokristall gemäß einem der vorangehenden Ansprüche, der einen Durchmesser von 15 bis 150 Å aufweist.

15. Nanokristall gemäß einem der vorangehenden Ansprüche, der außerdem eine oder mehrere, den Kern umgebende Schalen umfasst, wobei sich die Schalen aus einer Schicht aus einem Metall und/oder wenigstens einer wenigstens ein Metall umfassenden Halbleiterverbindung zusammensetzen.

16. Nanokristall gemäß Anspruch 15, bei dem der Kern einen Durchmesser von 15 bis 150 Å aufweist und die Schale(n) eine Dicke von 3 bis 30 Å aufweist (aufweisen).

17. Nanokristall gemäß einem der vorangehenden Ansprüche, bei dem die organische Überzugsschicht eine Dicke von 5 bis 100 Å aufweist.

18. Nanokristall gemäß Anspruch 15, bei dem der Kern eine erste Halbleiterverbindung ist und die einzige, den Kern umgebende Schale, wenn es eine einzige Schale gibt, oder die erste, den Kern umgebende Schale, wenn es mehrere Schalen gibt, aus einer zweiten, sich von der ersten Halbleiterverbindung unterscheidenden Halbleiterverbindung ist.

19. Nanokristall gemäß Anspruch 18, bei dem die erste Halbleiterverbindung eine Halbleiterverbindung des Typs A(II)B(VI) wie etwa CdSe ist und die zweite Verbindung eine von der ersten Verbindung verschiedene Halbleiterverbindung des Typs A(II)B(VI) wie etwa ZnSe, ZnS oder CdS ist.

20. Nanokristall gemäß einem der Ansprüche 15 bis 19, der mehrere Schalen umfasst, wobei zwei aufeinander folgende Schalen aus verschiedenen Halbleiterverbindungen sind, die zum Beispiel aus ZnSe, CdS, ZnS ausgewählt sind.

21. Nanokristall gemäß Anspruch 20, der eine erste Schale aus ZnSe oder CdS und eine zweite Schale aus ZnS umfasst.

22. Nanokristall gemäß einem der vorangehenden Ansprüche, bei dem Y der folgenden Formel entspricht:
-R₁-R- (II)
worin
R₁
• eine Einfachbindung,
• eine Gruppe 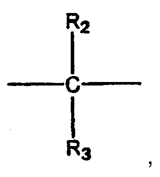 worin R₂ und R₃ unabhängig Wasserstoff, einen Alkylrest, einen Arylrest, einen Alkoxyrest oder ein Halogen darstellen,
• eine Gruppe 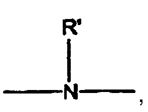 worin R' Wasserstoff, einen Alkylrest, einen Arylrest, einen Alkoxyrest oder ein Halogen darstellen,
• eine Gruppe 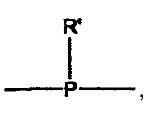 worin R' die bereits weiter oben angegebene Bedeutung aufweist,
• eine Gruppe 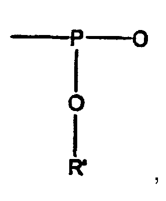 worin R' die bereits weiter oben angegebene Bedeutung aufweist,
• -O-,
• -S- oder
• -Se- darstellt
und R eine gerade oder verzweigte Alkylengruppe mit 1 bis 30, vorzugsweise 1 bis 8 Kohlenstoffatomen darstellt, wobei ein oder mehr Kohlenstoffatome der Alkylengruppe gegebenenfalls durch ein oder mehr aus O, N, S, P und Si ausgewählte Heteroatome ersetzt sind, die Alkylengruppe außerdem gegebenenfalls eine oder mehr Doppel- und/oder Dreifachbindungen wie etwa Kohlenstoff-Kohlenstoff-Doppel- und/oder -Dreifachbindungen umfasst und die Alkylengruppe außerdem gegebenenfalls durch eine oder mehr aus Halogenen wie etwa Chlor, Brom, lod und Fluor, Heterocyclen, Aryl-, Hydroxy-, Alkoxy-, Amino-, Acyl-, Carbonsäureamidoresten, =O, -CHO, -CO₂H, -SO₃H PO₃H₂, -PO₄H₂, -NHSO₃H Sulfonamid, Monoalkylamino, Trialkylammonium ausgewählte Gruppen oder sogar durch einen Dialkylaminorest, bei dem die beiden Alkylgruppen zusammen mit dem Stickstoffatom der Dialkyl(C₁-C₄)aminogruppe, an das sie gebunden sind, einen Ring bilden können, der durch ein oder mehr Stickstoff-, Sauerstoff- oder Schwefelatome unterbrochen sein kann, und die Gruppen Z substituiert sein kann oder R einen Heterocyclus, einen Arylrest, einen mit einem oder mehr Arylringen und/oder Alkylringen und/oder Heterocyclen kondensierten Arylrest, einen Cycloalkylrest, einen Cycloalkylalkylrest, einen Alkylcycloalkyl, einen Arylalkylrest, einen Alkylarylrest, einen Heterocycloalkylrest oder einen Alkylheterocycloalkylrest darstellt.

23. Nanokristall gemäß Anspruch 22, bei dem Y eine Alkylenkette -(CH₂)ₙ- mit n = 1 bis 18, vorzugsweise n = 12 oder einen gegebenenfalls substituierten aromatischen Ring wie etwa 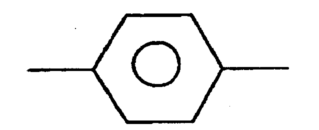 oder eine Alkoxykette -[(CH₂)ₘO(CH₂)ₘ]ₙ- mit m = 1 bis 4 und n = 1 bis 6 darstellt.

24. Nanokristall gemäß einem der vorangehenden Ansprüche, bei dem die Gruppe Z zum Erhalten einer Löslichkeit des Nanokristalls in einem durch eine gegebene Polarität definierten, speziellen Lösungsmittel ausgewählt ist.

25. Nanokristall gemäß Anspruch 24, bei dem die Gruppe Z aus den Gruppen ausgewählt ist, die das Löslichmachen des Nanokristalls in unpolaren Lösungsmitteln und/oder Lösungsmitteln mit geringer Polarität wie etwa Kohlenwasserstoffen ermöglichen.

26. Nanokristall gemäß Anspruch 24, bei dem die Gruppe Z aus den Gruppen ausgewählt ist, die das Löslichmachen des Nanokristalls in polaren Lösungsmitteln wie etwa Wasser, Alkoholen und ihren Gemischen ermöglichen.

27. Nanokristall gemäß einem der vorangehenden Ansprüche, bei dem die Gruppe Z aus den Gruppen ausgewählt ist, die die Bindung des Nanokristalls mit anderen Molekülen wie etwa biologischen Molekülen und konjugierten Polymeren und Oligomeren ermöglichen.

28. Nanokristall gemäß einem der vorangehenden Ansprüche, bei dem die Gruppe Z konjugierte Polymere oder Oligomere oder biologische Moleküle enthält.

29. Nanokristall gemäß einem der vorangehenden Ansprüche, bei dem die Gruppe Z aus den Gruppen ausgewählt ist, die die Bindung des Nanokristalls mit einem oder mehreren weiteren Nanokristallen ermöglichen.

30. Nanokristall gemäß einem der vorangehenden Ansprüche, bei dem die Gruppe Z aus hydrophilen Gruppen, insbesondere polaren Gruppen wie etwa Hydroxygruppen, Formylgruppen, Alkoxiden, Carbonsäuren, Aminen, Polyethern wie etwa Polyethylenglykol und geladenen Gruppen wie etwa Carboxylatgruppen, Sulfonaten, Phosphaten, Nitraten, Ammoniumsalzen und Analoga ausgewählt ist.

31. Nanokristall gemäß einem der vorangehenden Ansprüche, bei dem die Gruppe Z mit der Gruppe X identisch ist.

32. Nanokristall gemäß einem der vorangehenden Ansprüche, bei dem mehrere identische oder verschiedene Gruppen Z an demselben Liganden vorhanden sind.

33. Nanokristall gemäß einem der vorangehenden Ansprüche, bei dem mehrere Gruppen X an demselben Liganden vorhanden sind.

34. Nanokristall gemäß einem der vorangehenden Ansprüche, bei dem mehrere Liganden, die sich von der oder den Gruppen Y und/oder Z unterscheiden, die sie enthalten, auf demselben Nanokristall befinden.

35. Nanokristall gemäß einem der vorangehenden Ansprüche, wobei der Nanokristall ein fluoreszierender, photolumineszierender Nanokristall ist.

36. Nanokristall gemäß Anspruch 35, wobei der fluoreszierende, photolumineszierende Nanokristall einer Bestrahlung durch Licht unterzogen wird.

37. Nanokristall gemäß Anspruch 36, wobei das Licht Ultraviolettlicht ist.

38. Verfahren zur Herstellung eines Nanokristalls gemäß einem der Ansprüche 1 bis 37, wobei die folgenden, aufeinander folgenden Schritte ausgeführt werden:
a) eine Lösung eines Nanokristalls, der einen anorganischen Kern, der sich aus wenigstens einem Metall und/oder wenigstens einer wenigstens ein Metall umfassenden Halbleiterverbindung zusammensetzt und gegebenenfalls eine oder mehrere, den Kern umgebende Schale(n) aufweist, wobei sich die Schale(n) aus einer Schicht aus einem Metall und/oder wenigstens einer wenigstens ein Metall umfassenden Halbleiterverbindung zusammensetzt (zusammensetzen) und die äußere Oberfläche des Nanokristalls mit einer organischen Überzugsschicht versehen ist, die sich aus wenigstens einer ersten, von der Ligandenverbindung der Formel (I) verschiedenen Ligandenverbindung zusammensetzt, wird in einem Lösungsmittel hergestellt,
b) der Lösung des Schritts a) werden in dem Lösungsmittel der Lösung des Schritts a) lösliche Ligandenverbindungen der Formel (I) derart zugesetzt, dass die Ligandenverbindungen der Formel (I) in Bezug auf die ersten, von der Ligandenverbindung der Formel (I) verschiedenen Ligandenverbindungen, mit denen die Nanokristalle versehen sind, im Überschuss vorliegen,
c) die Ligandenverbindungen der Formel (I) und die Nanokristalle werden vorzugsweise unter Rühren über einen zum Durchführen eines im Wesentlichen vollständigen Austausches der ersten Ligandenverbindungen durch die Ligandenverbindungen der Formel (I) auf der Oberfläche der Nanokristalle ausreichenden Zeitraum in Kontakt belassen.

39. Verfahren gemäß Anspruch 38, wobei in Schritt b) die Ligandenverbindungen der Formel (I) der Lösung des Schritts a) in der Säureform HS(S)C-Y-Z oder HSe(Se)C-Y-Z oder Salzform M⁽⁺⁾S(S)C-Y-Z⁽⁻⁾ oder M⁽⁺⁾Se(Se)C-Y-Z⁽⁻⁾, worin M⁽⁺⁾ = Li⁽⁺⁾, Na⁽⁺⁾, K⁽⁺⁾, Rb⁽⁺⁾, Cs⁽⁺⁾, NH₄⁽⁺⁾ oder PH₄⁽⁺⁾, zugefügt werden.

40. Verfahren gemäß Anspruch 38, wobei in Schritt b) das Molverhältnis der den ersten Ligandenverbindungen zugesetzten Ligandenverbindungen der Formel (I) 5:1 bis 15:1 ist.

41. Verfahren gemäß Anspruch 38, wobei die Kontaktzeit für Schritt c) 1 bis 5 Stunden beträgt.

42. Verfahren gemäß einem der Ansprüche 38 bis 41, wobei das Lösungsmittel aus Chloroform, Dichlormethan, Toluol, Heptan oder einem weiteren unpolaren Lösungsmittel oder Lösungsmittel mit niedriger Polarität oder einem Gemisch derselben ausgewählt wird.

43. Verfahren zur Herstellung eines Nanokristalls gemäß einem der Ansprüche 1 bis 37, wobei die folgenden aufeinander folgenden Schritte ausgeführt werden:
a) eine Lösung eines Nanokristalls, der einen anorganischen Kern, der sich aus wenigstens einem Metall und/oder wenigstens einer wenigstens ein Metall umfassenden Halbleiterverbindung zusammensetzt und gegebenenfalls eine oder mehrere, den Kern umgebende Schale(n) aufweist, wobei sich die Schale(n) aus einer Schicht aus einem Metall und/oder wenigstens einer wenigstens ein Metall umfassenden Halbleiterverbindung zusammensetzt (zusammensetzen) und die äußere Oberfläche des Nanokristalls mit einer organischen Überzugsschicht versehen ist, die sich aus wenigstens einer ersten, von der Ligandenverbindung der Formel (I) verschiedenen Ligandenverbindung zusammensetzt, wird in einem ersten Lösungsmittel hergestellt,
b) der Lösung des Schritts a) wird eine Lösung der Ligandenverbindungen der Formel (I) in einem zweiten Lösungsmittel zugesetzt, wobei die Ligandenverbindungen der Formel (I) in dem ersten Lösungsmittel nicht löslich sind, wodurch ein Zweiphasengemisch erhalten wird, das eine erste, sich aus der Lösung der Nanokristalle in dem ersten Lösungsmittel zusammensetzende Phase und eine zweite, sich aus der Lösung der Ligandenverbindungen der Formel (I) in dem zweiten Lösungsmittel zusammensetzende Phase umfasst,
c) die erste und zweite Phase werden vorzugsweise unter Rühren über einen Zeitraum, der dazu ausreicht, die Nanokristalle im Wesentlichen vollständig in die zweite Phase zu überführen und an der Oberfläche der Nanokristalle einen im Wesentlichen vollständigen Austausch der ersten Ligandenverbindungen durch die Ligandenverbindungen der Formel (I) durchzuführen, in Kontakt belassen.

44. Verfahren gemäß Anspruch 43, wobei in Schritt b) die Ligandenverbindungen der Formel (I) der Lösung des Schritts a) in der Säureform HS(S)C-Y-Z oder HSe(Se)C-Y-Z oder Salzform M(⁺)S(S)C-Y-Z(-) oder M(⁺)Se(Se)C-Y-Z(-), worin M(⁺) = Li(⁺), Na(⁺), K(⁺), Rb(⁺), Cs(⁺), NH₄(⁺) oder PH₄(⁺), zugefügt werden.

45. Verfahren gemäß Anspruch 44, wobei die Kontaktzeit für Schritt c) 1 bis 5 Stunden beträgt.

46. Verfahren gemäß einem der Ansprüche 43 bis 45, wobei das erste Lösungsmittel aus unpolaren Lösungsmitteln und Lösungsmitteln mit niedriger Polarität wie etwa Chloroform, Dichlormethan, Toluol, Heptan, Hexan und Gemischen davon ausgewählt wird.

47. Verfahren gemäß einem der Ansprüche 43 bis 46, wobei das zweite Lösungsmittel aus polaren Lösungsmitteln wie etwa Alkoholen wie etwa Methanol und Ethanol, Wasser und Gemischen davon ausgewählt wird.

48. Verfahren gemäß einem der Ansprüche 38 bis 47, wobei die erste, von der Ligandenverbindung der Formel (I) verschiedene Ligandenverbindung aus Phosphinoxiden wie etwa Trialkylphosphinoxid, bei dem die Alkylgruppe 4 bis 12 Kohlenstoffatome umfasst, wie etwa Trioctylphosphinoxid (TOPO), Phosphinseleniden wie etwa Trialkylphosphinseleniden, bei denen die Alkylgruppe 4 bis 12 Kohlenstoffatome umfasst, wie etwa Trioctylphosphinselenid (TOPSe), Trialkylphosphinen wie etwa Trialkylphosphinen, bei denen die Alkylgruppe 4 bis 12 Kohlenstoffatome umfasst, wie etwa Trioctylphosphin (TOP), primären Aminen wie etwa Alkylaminen, bei denen die Alkylgruppe 6 bis 24 Kohlenstoffatome umfasst, wie etwa Hexadecylamin (HDA), Thiolen wie etwa Dodecanthiol und Carbonsäuren wie etwa Stearinsäure oder Ölsäure und Gemischen davon ausgewählt wird.

49. Verfahren gemäß einem der Ansprüche 38 bis 48, wobei am Ende von Schritt c) die mit einer sich aus Liganden (I) zusammensetzenden organischen Überzugsschicht versehenen Nanokristalle gefällt, abgetrennt, gewaschen und anschließend getrocknet werden.

50. Verfahren gemäß einem der Ansprüche 38 bis 49, wobei die mit einer sich aus Liganden (I) zusammensetzenden organischen Überzugsschicht versehenen Nanokristalle fluoreszierende, photolumineszierende Nanokristalle sind.

51. Verfahren gemäß Anspruch 50, wobei am Ende von Schritt c) die mit einer sich aus Liganden (I) zusammensetzenden organischen Überzugsschicht versehenen Nanokristalle, die gegebenenfalls gefällt, abgetrennt, gewaschen und anschließend getrocknet werden, einer Bestrahlung mit Licht unterzogen werden.

52. Verfahren gemäß Anspruch 51, wobei das Licht Ultraviolettlicht mit zum Beispiel einer Wellenlänge von 365 nm ist.

53. Verfahren gemäß einem der Ansprüche 51 bis 52, wobei die Bestrahlung eine Minute bis 10 Stunden, vorzugsweise 10 Minuten bis 200 Minuten, noch bevorzugter 50 bis 100 Minuten, zum Beispiel 60 Minuten dauert.

54. Verfahren gemäß einem der Ansprüche 51 bis 53, wobei die Bestrahlung durch Dispergieren der mit einer sich aus Liganden (I) zusammensetzenden organischen Überzugsschicht versehenen Nanokristalle in einem Lösungsmittel und Aussetzen der Nanokristalle einer Bestrahlung mit Licht durchgeführt wird.

55. Verfahren gemäß Anspruch 54, wobei das Lösungsmittel aus unpolaren Lösungsmitteln und Lösungsmittel mit niedriger Polarität wie etwa Chloroform, Dichlormethan, Toluol, Heptan, Hexan und Gemischen davon oder aus polaren Lösungsmitteln wie etwa Alkoholen, Wasser und Gemischen davon ausgewählt wird.
